(19) Europäisches Patentamt
European Patent Office
Office européen des brevets

(11) Veröffentlichungsnummer: **0 401 165 B1**

# (12) EUROPÄISCHE PATENTSCHRIFT

(45) Veröffentlichungstag der Patentschrift: **30.11.94**

(51) Int. Cl.[5]: **C07F 17/00**, C07F 7/28, C08F 2/50, G03F 7/027

(21) Anmeldenummer: **90810377.3**

(22) Anmeldetag: **23.05.90**

Die Akte enthält technische Angaben, die nach dem Eingang der Anmeldung eingereicht wurden und die nicht in dieser Patentschrift enthalten sind.

## (54) Neue sauerstoffhaltige Titanocene und deren Verwendung.

(30) Priorität: **01.06.89 CH 2074/89**

(43) Veröffentlichungstag der Anmeldung: **05.12.90 Patentblatt 90/49**

(45) Bekanntmachung des Hinweises auf die Patenterteilung: **30.11.94 Patentblatt 94/48**

(84) Benannte Vertragsstaaten: **DE FR GB IT**

(56) Entgegenhaltungen:
**EP-A- 0 186 626**
**EP-A- 0 318 893**
**EP-A- 0 318 894**

(73) Patentinhaber: **CIBA-GEIGY AG**
**Klybeckstrasse 141**
**CH-4002 Basel (CH)**

(72) Erfinder: **Steiner, Eginhard, Dr.**
**Obere Hofackerstrasse 3**
**CH-4414 Füllinsdorf (CH)**
Erfinder: **Beyeler, Harry**
**Marignanostrasse 35**
**CH-4059 Basel (CH)**
Erfinder: **Riediker, Martin, Dr.**
**Haldenstrasse 3**
**CH-8427 Rorbas (CH)**
Erfinder: **Desobry, Vincent, Dr.**
**Route du Confin 50**
**CH-1723 Marly (CH)**
Erfinder: **Dietliker, Kurt, Dr.**
**Ave. Jean-Marie Musy 6**
**CH-1700 Fribourg (CH)**
Erfinder: **Hüsler, Rinaldo, Dr.**
**Dorfstrasse 52**
**CH-3184 Wünnewil (CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services
(3.10/3.09/3.3.3)

## Beschreibung

Die vorliegende Erfindung betrifft Titanocene mit fluorhaltigen aromatischen Resten, die veresterte Sauerstoffunktionen tragen, ein Verfahren zu ihrer Herstellung und ihre Verwendung als Photoinitiatoren zur Polymerisation ethylenisch ungesättigter Verbindungen.

Aus der US-A 4,590,287 ist es bekannt, dass Titanocene mit Fluorarylliganden ausgezeichnete Photoinitiatoren sind. Die Fluorarylliganden dieser Titanocene können zum Beispiel mit Hydroxyl, Alkoxy, Carboxyl, Alkoxycarbonyl oder Aminocarbonyl substituiert sein. In der US-A 4,857,654 sind Titanocene mit Polyoxaalkylenketten am Fluorarylliganden veröffentlicht. Die EP-A 256981 beschreibt Titanocene mit silylierten Cyclopentadienylresten. Aus der EP-A 318894 sind Titanocene mit pyrrolsubstituenten am Fluorarylliganden bekannt, in der EP-A 318893 sind Titanocene mit stickstoffhaltigen Liganden am Fluorarylrest beschrieben, und in der US-A 4,713,401 sind Titanocene veröffentlicht, die am Arylliganden anstelle der Fluoratome $CF_3$-Substituenten besitzen. Substitutionen mit Acyloxygruppen, Carbamoyloxygruppen, Sulfonyloxygruppen oder Siloxygruppen sind bisher nicht bekannt geworden. Es hat sich jedoch gezeigt, dass solcherart substituierte Titanocene ebenfalls ausgezeichnete Photoinitiatoren sind und sich durch verbesserte Löslichkeit auszeichnen.

Gegenstand der Erfindung sind Titanocene der Formel I

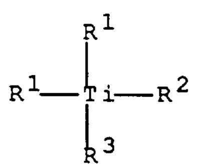

(I),

worin beide $R^1$ unabhängig voneinander gegebenenfalls ein- oder mehrfach durch $C_1$-$C_{18}$-Alkyl oder -Alkoxy, $C_2$-$C_{18}$-Alkenyl, $C_5$-$C_8$-Cycloalkyl, $C_6$-$C_{10}$-Aryl, $C_7$-$C_{16}$-Aralkyl, -Si$(R^4)_3$, -Ge$(R^4)_3$, Cyano oder Halogen substituiertes Cyclopentadienyl$^{\ominus}$, Indenyl$^{\ominus}$ oder 4,5,6,7-Tetrahydroindenyl$^{\ominus}$ bedeuten und $R^4$ $C_1$-$C_{12}$-Alkyl, $C_5$-$C_8$-Cycloalkyl, $C_6$-$C_{10}$-Aryl oder $C_7$-$C_{16}$-Aralkyl bedeutet, $R^2$ einen 6-gliedrigen carbocyclischen oder 5- oder 6-gliedrigen heterocyclischen aromatischen Ring bedeutet, der mindestens in den beiden ortho-Stellungen zur Titankohlenstoffbindung mit Fluoratomen substituiert ist und wobei der aromatische Ring weitere Substituenten enthalten kann, $R^3$ unabhängig die Bedeutung von $R^2$ hat, wobei die Titanocene dadurch gekennzeichnet sind, dass $R^2$ und $R^3$ durch einen Rest der Formel II substituiert sind,

-O-Y-$R^5$ (II)

worin Y eine Gruppe -CO-, -CS-, -CO-O-, -$SO_2$-, -Si$(R^4)_2$-, -CO-$NR^6$-, -CS-$NR^6$ oder -$SO_2$-$NR^6$- ist, $R^5$ lineares oder verzweigtes $C_1$-$C_{20}$-Alkyl, $C_2$-$C_{20}$-Alkenyl, $C_3$-$C_8$-Cycloalkyl, $C_4$-$C_{20}$-Cycloalkylalkyl, $C_4$-$C_{20}$-Alkylcycloalkyl, $C_5$-$C_{20}$-Alkylcycloalkylalkyl, $C_6$-$C_{20}$-Cycloalkenylalkyl, $C_7$-$C_{20}$-Bicycloalkyl, $C_6$-$C_{14}$-Aryl, $C_7$-$C_{12}$-Aralkyl, $C_7$-$C_{20}$-Alkylaryl oder $C_8$-$C_{20}$-Alkylaralkyl bedeutet, wobei diese Reste unsubstituiert oder durch $C_1$-$C_{18}$-Alkoxy, $C_1$-$C_{12}$-Alkylthio, $C_1$-$C_{18}$-Alkylsulfonyl, $C_6$-$C_{10}$-Arylsulfonyl, $C_7$-$C_{20}$-Alkylarylsulfonyl, -COOH, -CN, -$COOR^4$, -CO-($C_1$-$C_{20}$-Alkyl) oder Halogen substituiert sind, $R^6$ Wasserstoff ist oder eine der für $R^5$ genannten Bedeutungen hat oder $R^5$ und $R^6$ zusammen $C_3$-$C_7$-Alkylen bedeuten, das durch -O-, -S- oder - N$(R^7)$- unterbrochen sein kann, worin $R^7$ Wasserstoff, $C_1$-$C_{12}$-Alkyl, $C_3$-$C_{12}$-Alkenyl, $C_7$-$C_{12}$-Aralkyl oder $C_2$-$C_{20}$-Alkanoyl bedeutet.

Bei den Gruppen $R^1$ handelt es sich bevorzugt um gleiche Reste. Als Substituenten kommen für $R^1$ in Frage: lineares oder verzweigtes Alkyl oder Alkoxy mit 1 bis 18, besonders 1 bis 12 und insbesondere 1 bis 6 C-Atomen, und Alkenyl mit 2 bis 18, besonders 2 bis 12, und insbesondere 2 bis 6 C-Atomen, wie z.B. Methyl, Ethyl, Propyl, Isopropyl, n-Butyl, tert.-Butyl, Pentyl, Hexyl, Octyl, Decyl, Dodecyl, Tetradecyl, Hexadecyl, Octadecyl und entsprechende Alkenyl- und Alkoxygruppen; Cycloalkyl mit 5 bis 8 Ringkohlenstoffatomen wie z.B. Cyclopentyl, Cyclohexyl, Cycloheptyl, Methylcyclopentyl und Methylcyclohexyl; Aryl mit 6 bis 10 C-Atomen und Aralkyl mit 7 bis 16 C-Atomen wie z.B. Phenyl, Naphthyl, Benzyl und Phenylethyl; Cyano und Halogen, besonders F, Cl und Br; -Si$(R^4)_3$ oder -Ge$(R^4)_3$, worin $R^4$ bevorzugt $C_1$-$C_8$-Alkyl, Cyclohexyl, Phenyl oder Benzyl ist. Beispiele für $R^4$ in der Bedeutung von Alkyl sind Methyl, Ethyl, n- und i-Propyl, n-, i- und t-Butyl, Pentyl, Hexyl, Heptyl und Octyl.

Die Reste $R^1$ können bis zu 5, besonders aber bis zu 3 Substituenten enthalten. Bevorzugt sind beide $R^1$ Cyclopentadienyl$^{\ominus}$- oder Methylcyclopentadienyl$^{\ominus}$-Reste, insbesondere Cyclopentadienyl$^{\ominus}$-Reste.

$R^2$ in seiner Bedeutung als 6-gliedriger carbocyclischer aromatischer, durch mindestens 2 Fluor substituierter Ring kann z.B. fluorsubstituiertes Indenyl, Indanyl, Fluorenyl, Naphthyl oder Phenyl sein, die durch einen Rest der Formel II substituiert sind. $R^2$ in seiner Bedeutung als 5- oder 6-gliedriges heterocyclischer aromatischer, durch mindestens 2 Fluor substituierten Ring kann 1 oder 2 Heteroatome enthalten und kann z.B. fluorsubstituiertes Furyl, Thienyl, Pyrryl, Pyridyl, Pyrimidyl oder Pyridazyl sein, die durch einen Rest der Formel II substituiert sind. Bevorzugt ist $R^2$ ein carbocyclischer Ring.

$R^3$ hat bevorzugt dieselbe Bedeutung wie $R^2$.

Bevorzugt sind $R^2$ und $R^3$ 2,6-Difluorphen-1-yl, an das ein Rest der Formel II gebunden ist und das weitere 1 oder 2 gleiche oder verschiedene Substituenten enthalten kann.

Bevorzugt sind $R^2$ und $R^3$ eine Gruppe der Formel III

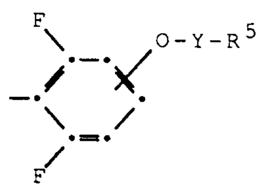

III ,

worin Y und $R^5$ die oben gegebene Bedeutung haben. Bevorzugt steht in Formel III die Gruppe -O-Y-$R^5$ in Orthostellung zu einem Fluoratom. In diesem Fall ist $R^2$ eine Gruppe der Formel IIIa

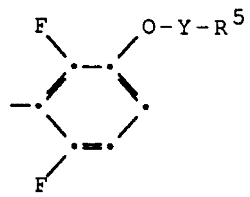

IIIa .

$R^2$ und $R^3$ können bevorzugt auch eine Gruppe der Formel IV sein,

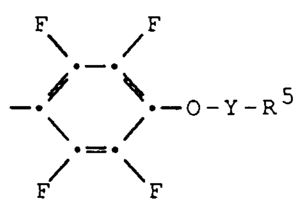

IV

worin Y und $R^5$ die oben gegebene Bedeutung haben.

Bei $R^5$ kann es sich um lineares oder verzweigtes $C_1$-$C_{20}$-, bevorzugt $C_1$-$C_{12}$- und besonders $C_1$-$C_8$-Alkyl handeln. Beispiele sind Methyl, Ethyl und die Isomeren von Propyl, Butyl, Pentyl, Hexyl, Heptyl, Octyl, Nonyl, Decyl, Undecyl, Dodecyl, Tetradecyl, Hexadecyl und Octadecyl. $R^5$ kann $C_3$-$C_8$-, bevorzugt $C_5$- bis $C_8$- und besonders $C_5$-oder $C_6$-Cycloalkyl sein, z.B. Cyclopropyl, Cyclobutyl, Cyclopentyl, Cylohexyl, Cycloheptyl und Cyclooctyl. $R^5$ kann $C_4$-$C_{20}$-, bevorzugt $C_6$-$C_{15}$-Cycloalkylalkyl oder - Alkylcycloalkyl sein, wobei das Cycloalkyl vorzugsweise Cyclopentyl oder Cyclohexyl ist. Beispiele sind Cyclopentyl- oder Cyclohexylmethyl, Cyclopentyl- oder Cyclohexylethyl, Cyclopentyl-oder Cyclohexylpropyl, Cyclopentyl- oder Cyclohexylbutyl, Methyl-, Dimethyl-, Ethyl-, n-Propyl-, i-Propyl-, n-Butyl-, i-Butyl-, t-Butylcyclopentyl oder - cyclohexyl. $R^5$ kann $C_5$-$C_{20}$-, bevorzugt $C_7$-$C_{16}$-Alkylcycloalkylalkyl bedeuten, z.B. (Methylcyclopentyl)methyl oder -ethyl, (Methylcyclohexyl)methyl oder -ethyl.

Bei $R^5$ kann es sich auch um $C_6$-$C_{14}$-, bevorzugt $C_6$-$C_{10}$-Aryl handeln, z.B. Naphthyl und besonders Phenyl. $R^5$ kann auch $C_7$-$C_{20}$-, bevorzugt $C_7$-$C_{16}$-Aralkyl oder -Alkaryl sein. Das Aryl ist hierbei bevorzugt ein Phenylrest. Beispiele sind Benzyl, Phenylethyl, Phenylpropyl, Phenylbutyl, Methylphenyl, Ethylphenyl,

Propylphenyl und Butylphenyl. Bei $R^5$ kann es sich auch um $C_8$-$C_{20}$-, bevorzugt $C_8$-$C_{16}$-Alkaralkyl handeln, worin das Aryl bevorzugt Phenyl ist Beispiele sind Methylbenzyl, (Methylphenyl)ethyl, (Methylphenyl)propyl, (Methylphenyl)butyl, Ethylbenzyl und Propylbenzyl.

Diese Kohlenwasserstoffreste können substituiert sein durch $C_1$-$C_{18}$-Alkoxy, insbesondere $C_1$-$C_{12}$-Alkoxy oder $C_1$-$C_4$-Alkoxy; durch $C_1$-$C_{12}$-Alkylthio, insbesondere $C_1$-$C_4$-Alkylthio; durch $C_1$-$C_{18}$-Alkylsulfonyl, $C_6$-$C_{10}$-Arylsulfonyl, $C_7$-$C_{20}$-Alkylarylsulfonyl, -COOH, -CN -COOR$^4$, -CO-($C_1$-$C_{20}$-Alkyl) oder durch Halogen. Beispiele für solche substituierte $R^5$-Reste sind Trichlormethyl, Trifluormethyl, 4-Chlorphenyl, 3-Bromphenyl, 4-Methoxyphenyl, 4-Methylthiophenyl, Carboxyethyl, Carboxyvinyl, Carboxyphenyl, Cyanomethyl, Cyanoethyl oder Acetylmethyl.

Wenn $R^5$ und $R^6$ zusammen $C_3$-$C_7$-Alkylen bedeuten, das durch -O-, -S- oder - N($R^7$)- unterbrochen sein kann, so bilden sie zusammen mit dem N-Atom, an das sie gebunden sind, einen heterocyclischen Ring, z.B. einen Pyrrolidin-, Piperdin-, Methylpiperidin-, Morpholin-, Thiomorpholin-, Piperazin-, N-Methylpiperazin-, N-Benzylpiperazin- oder N-Acetylpiperazinring.

Bevorzugte Titanocene der Formel I sind solche, worin $R^2$ und $R^3$ eine Gruppe der Formel III oder IV darstellen, worin Y -CO-, -CO-O-, -$SO_2$-, -CO-NR$^6$-, -CS-NH- oder -$SO_2$NR$^6$- bedeutet, $R^5$ $C_1$-$C_{12}$-Alkyl, Cyclohexyl, $C_2$-$C_5$-Alkenyl, Cyclohexylmethyl, $C_7$-$C_{12}$-Aralkyl, $C_6$-$C_{10}$-Aryl, durch Cl, $C_1$-$C_4$-Alkyl oder $C_1$-$C_4$-Alkoxy substituiertes Phenyl, $C_1$-$C_4$-Halogenalkyl oder $C_2$-$C_8$-Alkoxyalkyl bedeutet, $R^6$ Wasserstoff ist oder eine der für $R^5$ gegebenen Bedeutungen hat oder $R^5$ und $R^6$ zusammen $C_4$-$C_5$-Alkylen oder 3-Oxapentamethylen bedeuten.

Eine weitere bevorzugte Gruppe von Verbindungen sind Titanocene der Formel I, worin $R^1$ Cyclopentadienyl$^\ominus$ oder Methylcyclopentadienyl$^\ominus$ ist, $R^2$ und $R^3$ eine Gruppe der Formel III oder IV bedeuten, worin entweder

a) Y -CO- oder -$SO_2$- ist und $R^5$ $C_1$-$C_{20}$-Alkyl, $C_2$-$C_8$-Alkenyl, $C_5$-$C_6$-Cycloalkyl, $C_6$-$C_{14}$-Alkylcycloalkyl, $C_6$-$C_{10}$-Aryl, $C_7$-$C_{18}$-Alkaryl oder Chlorphenyl bedeutet, oder
b) Y -CO-O- ist und $R^5$ $C_1$-$C_8$-Alkyl oder Phenyl bedeutet, oder
c) Y -CO-NR$^6$- ist und $R^5$ $C_1$-$C_{12}$-Alkyl, Cyclohexyl oder Phenyl bedeutet und $R^6$ Wasserstoff oder $C_1$-$C_4$-Alkyl bedeutet oder $R^5$ und $R^6$ zusammen Pentamethylen oder 3-oxapentamethylen bedeuten, oder
d) Y -CO-O- ist und $R^5$ $C_1$-$C_8$-Alkyl oder Phenyl bedeutet, oder
e) Y -Si($R^4$)$_2$- ist und $R^4$ $C_1$-$C_4$-Alkyl ist und $R^5$ $C_1$-$C_8$-Alkyl oder Phenyl bedeutet.

Besonders bevorzugt sind Titanocene der Formel I, worin $R^1$ Cyclopentadienyl$^\ominus$ ist und $R^2$ und $R^3$ eine Gruppe der Formel III oder IV bedeuten, worin entweder

a) Y -CO- ist und $R^5$ $C_1$-$C_{20}$-Alkyl oder $C_2$-$C_4$-Alkenyl bedeutet, oder
b) Y -CO-NR$^6$- ist und $R^5$ $C_1$-$C_6$-Alkyl und $R^6$ Wasserstoff oder $C_1$-$C_4$-Alkyl bedeuten, oder
c) Y -$SO_2$- ist und $R^5$ Phenyl oder p-Tolyl bedeutet.

Beispiele für einzelne Verbindungen der Formel I sind:
Bis(cyclopentadienyl)-bis(2,6-difluor-3-acetoxyphenyl)-titan,
Bis(cyclopentadienyl)-bis(2,6-difluor-3-propionyloxyphenyl)-titan,
Bis(cyclopentadienyl)-bis(2,6-difluor-3-decanoyloxyphenyl)-titan,
Bis(cyclopentadienyl)-bis(2,6-difluor-3-stearoyloxyphenyl)-titan,
Bis(cyclopentadienyl)-bis(2,6-difluor-3-methacryloyloxyphenyl)-titan,
Bis(cyclopentadienyl)-bis(2,6-difluor-3-butyryloxyphenyl)-titan,
Bis(cyclopentadienyl)-bis(2,6-difluor-3-isobutyryloxyphenyl)-titan,
Bis(cyclopentadienyl)-bis(2,6-difluor-3-lauroyloxyphenyl)-titan,
Bis(cyclopentadienyl)-bis(2,6-difluor-3-crotonyloxyphenyl)-titan,
Bis(cyclopentadienyl)-bis(2,6-difluor-3-oleyloxyphenyl)-titan,
Bis(cyclopentadienyl)-bis(2,6-difluor-3-benzoyloxyphenyl)-titan,
Bis(cyclopentadienyl)-bis[2,6-difluor-3-(4-toluyloxy)-phenyl]-titan,
Bis(cyclopentadienyl)-bis(2,6-difluor-3-thionoacetoxyphenyl)-titan,
Bis(cyclopentadienyl)-bis[2,6-difluor-3-((isopropylamino)carbonyloxy)-phenyl]-titan,
Bis(cyclopentadienyl)-bis[2,6-difluor-3-((butylamino)carbonyloxy)phenyl]-titan,
Bis(cyclopentadienyl)-bis[2,6-difluor-3-((2-methylpropyloxy)carbonyloxy)-phenyl]-titan,
Bis(cyclopentadienyl)-bis[2,6-difluor-3-(4-tolylsulfonyloxy)phenyl]-titan,
Bis(cyclopentadienyl)-bis[2,6-difluor-3-(phenylsulfonyloxy)phenyl]-titan,
Bis(cyclopentadienyl)-bis[2,6-difluor-3-(4-dodecylphenylsulfonyloxy)-phenyl]-titan,
Bis(cyclopentadienyl)-bis[2,3,5,6-tetrafluor-4-(4-tolylsulfonyloxy)-phenyl]-titan,
Bis(cyclopentadienyl)-bis(2,3,5,6-tetrafluor-4-butyryloxy-phenyl)-titan,
Bis(cyclopentadienyl)-bis[2,6-difluor-3-(morpholinocarbonyloxy)phenyl]-titan,
Bis(cyclopentadienyl)-bis[2,6-difluor-3-(dimethylaminocarbonyloxy)-phenyl]-titan,

Bis(cyclopentadienyl)-bis[2,6-difluor-3-((butylamino)thiocarbonyloxy)-phenyl]-titan, Bis(cyclopentadienyl)-bis[2,6-difluor-3-((phenylamino)thiocarbonyloxy)-phenyl]-titan, Bis(cyclopentadienyl)-bis[2,6-difluor-3-(dimethylsulfamyloxy)phenyl]-titan, Bis(cyclopentadienyl)-bis[2,6-difluor-3-(morpholinosulfamyloxy)phenyl]-titan, Bis(cyclopentadienyl)-bis[2,6-difluor-3-(trimethylsiloxy)phenyl]-titan, Bis(cyclopentadienyl)bis[2,6-difluor-3-(dimethyl(1,1,2-trimethyl-propyl)siloxy)phenyl]-titan, Bis(cyclopentadienyl)-bis[2,6-difluor-3-(dimethylphenyl-siloxy)phenyl]-titan, Bis(cyclopentadienyl)-bis[2,6-difluor-3(tert.-butyldimethyl-siloxy)-phenyl]-titan, Bis(cyclopentadienyl)-bis[2,6-difluor-3-(cyclohexylcarbonyloxy)phenyl]-titan, Bis(cyclopentadienyl)-bis[2,6-difluor-3-(3-(4-methylcyclohexyl)-propanoyloxy)phenyl]-titan, Bis(cyclopentadienyl)-bis[2,6-difluor-3-(3-phenylpropanoyloxy )phenyl]-titan, Bis(cyclopentadienyl)-bis[2,6-difluor-3-((4-methylpiperazino)carbonyloxy)-phenyl]-titan, Bis(cyclopentadienyl)-bis[2,6-difluor-3-(6-methoxy-adipoyloxy)phenyl]-titan, Bis(cyclopentadienyl)-bis[2,6-difluor-3-((5-ethoxypentan-1,5-dionyl)oxy)-phenyl]-titan, Bis(cyclopentadienyl)-bis[2,6-difluor-3-(2-butoxyethanoyloxy)phenyl]-titan, Bis(cyclopentadienyl)-bis(2,6-difluor-4-acetoxyphenyl)-titan, Bis(methylcyclopentadienyl)-bis(2,6-difluor-3-acetoxyphenyl)-titan, Bis(methylcyclopentadienyl)-bis[2,6-difluor-3-(4-tolylsulfonyloxy)-phenyl]-titan, Bis(trimethylsilylcyclopentadienyl)-bis(2,6-difluor-3-propionyloxy-phenyl)-titan, Bis(pentamethylcyclopentadienyl)-bis[2,6-difluor-3-((butylamino)-carbonyloxy)phenyl]-titan, Bis(indenyl)-bis(2,6-difluor-3-dodecanoyloxyphenyl)-titan, Bis(4,5,6,7-tetrahydroindenyl)-bis(2,6-difluor-3-acetoxyphenyl)-titan, Bis(cyclopentadienyl)-bis(2,6-difluor-3-methyl-4-propionyloxyphenyl)-titan, Bis(cyclopentadienyl)-bis(2,5,6-trifluor-3-acetoxyphenyl)-titan.

Die Herstellung der Titanocene der Formel I kann erfolgen durch Umsetzung von 1 Mol einer Verbindung der Formel V,

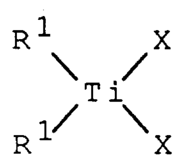

V

worin X Halogen, insbesondere Chlor bedeutet, mit je einem Mol der Aryllithiumverbindungen $LiR^2$ und $LiR^3$. Sind $R^2$ und $R^3$ identisch, so wird 1 Mol V mit 2 Mol $LiR^2$ umgesetzt. Die Durchführung dieser Reaktion geschieht in Analogie zu bekannten Verfahren zur Herstellung von Titanocenen aus Verbindungen der Formel V, wie sie beispielsweise in J. Organomet. Chem. 2(1964), 206 und 4(1965), 445 oder in der EP-A-122 223 beschrieben sind.

Bevorzugt geschieht die Herstellung der Titanocene der Formel I durch Einführung des Restes -Y-$R^5$ in die entsprechenden fluorierten Hydroxyaryltitanocene. Dies kann geschehen durch Umsetzung mit

a) einer Verbindung $R^5$-Y-X, worin X Halogen, vorzugsweise Chlor ist,
b) einer Verbindung $(R^5\text{-CO})_2O$ oder
c) einer Verbindung $R^5$-NCO oder $R^5$-NCS.

Gegenstand der Erfindung ist daher auch ein Verfahren zur Herstellung von Verbindungen der Formel I, worin $R^2$ und $R^3$ durch einen Rest der Formel -O-Y-$R^5$ substituiert sind durch Umsetzung von Verbindungen der Formel I, worin $R^2$ und $R^3$ durch eine Gruppe -OH substituiert sind, mit

a) entweder einer Verbindung $R^5$-Y-X, worin X Halogen, vorzugsweise Chlor, bedeutet, oder
b) mit einer Verbindung $(R^5CO)_2O$ oder
c) mit einer Verbindung $R^5NCO$ oder $R^5NCS$.

Bevorzugt werden hierbei Verbindungen der Formel I umgesetzt, worin $R^2$ und $R^3$ eine Gruppe der Formel VI oder VII sind:

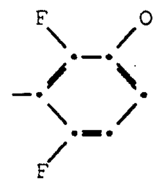 VI 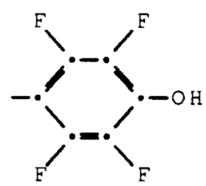 VII

Solche fluorierte Hydroxyphenyltitanocene, die hier als Zwischenprodukte verwendet werden, sind neue Verbindungen und ebenfalls Gegenstand der Erfindung.

Sie können hergestellt werden durch Hydrolyse von Verbindungen der Formel I, in denen $R^2$ und $R^3$ Gruppen der Formel VIII oder IX sind,

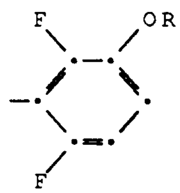 VIII 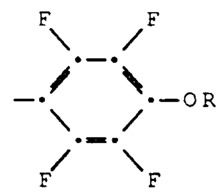 IX

worin R entweder eine Tetrahydropyranylgruppe ist oder eine Silylgruppe der Formel $-Si(R^4)_3$ ist, worin $R^4$ die vorhin gegebene Bedeutung hat. Bevorzugt ist $R^4$ $C_1$-$C_8$-Alkyl oder Phenyl, insbesondere Methyl.

Die Hydrolyse geschieht vorzugsweise in saurem Medium.

Die Reaktion der Hydroxyaryltitanocene mit einer Verbindung der Formel $R^5$-Y-X oder $(R^5CO)_2O$ geschieht vorzugsweise unter Zusatz von äquimolaren Mengen einer Base. Dies kann z.B. eine anorganische Base sein, wie ein Alkalimetallhydroxid oder ein Erdalkalimetall-Oxid oder -Hydroxid, oder ein organisches Amin, wie Tributylamin, Pyridin oder Dimethylanilin.

Die Umsetzung der Hydroxyaryltitanocene mit einer Verbindung $R^5$-NCO oder $R^5$-NCS kann durch Zusatz katalytischer Mengen einer Base beschleunigt werden. Als Base kann z.B. ein Trialkylamin oder eine heterocyclische Base verwendet werden.

Alle Umsetzungen der Titanocene werden vorzugsweise in einem inerten organischen Lösungsmittel ausgeführt. Hierfür eignen sich z.B. Benzol, Toluol, Xylol, Tetrahydrofuran, Dioxan, 1,2-Dichlorethan, Dimethylformamid oder Gemische solcher Lösungsmittel.

Die Verbindungen der Formel I sind im allgemeinen kristalline, meist orange-gefärbte, Verbindungen, die sich durch eine hohe thermische Stabilität auszeichnen und sich erst bei hohen Temperaturen zersetzen. Auch unter Lufteinwirkung wird keine Zersetzung beobachtet. Viele dieser Verbindungen können in härtbaren Zusammensetzungen auch in höheren Mengen gelöst werden, und bieten daher wertvolle anwendungstechnische Eigenschaften.

Die Verbindungen sind dunkellagerstabil und können ohne Schutzgas gehandhabt werden. Sie eignen sich alleine hervorragend als sehr wirksame Photoinitiatoren für die lichtinduzierte Polymerisation ethylenisch ungesättigter Verbindungen. Sie zeichnen sich hierbei durch eine sehr hohe Lichtempfindlichkeit und Wirksamkeit über einen grossen Wellenlängenbereich von ca. 200 nm (UV-Licht) bis etwa 600 nm aus. Ferner vermögen die Titanocene auch wirksam die Polymerisation unter dem Einfluss von Wärme zu initiieren, wobei ein Erwärmen auf 170 °C bis 240 °C zweckmässig ist. Selbstverständlich kann auch Lichteinwirkung und Erwärmung zur Polymerisation benutzt werden, wobei eine Erwärmung nach der Belichtung tiefere Temperaturen, z.B. 80-150 °C, zur Polymerisation erlaubt.

Ein weiterer Gegenstand vorliegender Erfindung ist eine durch Strahlung polymerisierbare Zusammensetzung, enthaltend (a) mindestens eine nicht-flüchtige, monomere, oligomere oder polymere Verbindung mit mindestens einer polymerisierbaren ethylenisch ungesättigten Doppelbindung und (b) mindestens ein Titanocen der Formel I als Photoinitiator.

Die Zusammensetzungen können weitere von (b) verschiedene Photoinitiatoren (c), z.B. solche vom Typ der Benzoinalkylether, Benzophenone, Benzilketale, 4-Aroyl-1,3-dioxolane, Dialkoxyacetophenone, $\alpha$-Hydroxy- oder $\alpha$-Aminoacetophenone, $\alpha$-Hydroxycycloalkylphenylketone oder Mischungen davon enthalten. Der Vorteil besteht darin, dass man geringere Mengen der erfindungsgemässen Titanocene verwenden kann und trotzdem gleiche oder verbesserte Lichtempfindlichkeiten erzielen kann. Das Gewichtsverhältnis

dieser Komponenten (c):(b) kann z.B. von 1:1 bis 30:1, bevorzugt 5:1 bis 15:1 betragen.

Die Zusatzmenge der erfindungsgemässen Titanocene richtet sich im wesentlichen nach wirtschaftlichen Gesichtspunkten, deren Löslichkeiten und nach der gewünschten Empfindlichkeit. Im allgemeinen werden 0,01 bis 20, vorzugsweise 0,05-10 und besonders 0,1 bis 5 Gew.% verwendet, bezogen auf die Komponente (a).

Als Komponente (a) kommen solche ethylenisch ungesättigten monomeren, oligomeren und polymeren Verbindungen in Frage, die durch Photopolymerisation zu höhermolekularen Produkten reagieren und hierbei ihre Löslichkeit verändern.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z.B. ungesättigte Polyester, Polyamide und Polyurethane und Copolymere davon, Polybutadien und Butadien-Copolymere, Polyisopren und Isopren-Copolymere, Polymere und Copolymere mit (Meth)-Acrylgruppen in Seitenketten, sowie Mischungen von zwei oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere oder Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3 oder 1,4-Butandiol, Pentandiol, Hexandiol, Octandiol, Dodecandiol, Diethylenglykol, Triethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind: Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat,Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldimethacrylat, 1,3-Butandioldiacrylat, 1,3-Butandioldimethacrylat, 1,4-Butandioldiitaconat, Sorbittriacrylat, Sorbittetraacrylat, Pentaerythritmodifiziert-triacrylat, Sorbittetramethacrylat, Sorbitpentaacrylat, Sorbithexaacrylat, Oligoesteracrylate und -methacrylate, Glyzerindi- und -triacrylat, 1,4-Cyclohexandioldiacrylat, Bisacrylate und Bismethacrylate von Polyethylenglykol mit Molekulargewicht von 200-1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di(β-aminopropoxy)ethan. Weitere geeignete Polyamine sind Polymere und Copolymere mit Aminogruppen in der Seitenkette und Oligoamide mit Aminoendgruppen.

Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen

ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolakbasis mit (Meth)- Acrylsäure handeln, um Homo- oder Copolymere des Polyvinylalkohols oder deren Hydroxyalkylderivaten, die mit (Meth)Acrylsäure verestert sind, oder um Homo- und Copolymere von (Meth)Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige Substanzen handelt. Die Menge des Bindemittels kann z.B. 5-95, vorzugsweise 10-90 und besonders 50-90 Gew.% betragen, bezogen auf die gesamte Zusammensetzung. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000 bis 1 000 000. Beispiele sind: Homo- und copolymere Acrylate und Methacrylate, z.B. Copolymere aus Methylmethacrylat/Ethylacrylat/Methacrylsäure, Poly(methacrylsäurealkylester), Poly-(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polyamide wie Polycaprolactam und Poly(hexamethylenadipamid), Polyester wie Poly(ethylenglykolterephthalat) und Poly-(hexamethylenglykolsuccinat).

Die erfindungsgemässen Zusammensetzungen eignen sich als Beschichtungsmittel für Substrate aller Art, z.B. Holz, Papier, Keramik, Kunststoffe, wie Polyester-und Celluloseacetatfilme, und Metalle, wie Kupfer und Aluminium, bei denen durch Photopolymerisation eine Schutzschicht oder eine photographische Abbildung aufgebracht werden soll. Ein weiterer Gegenstand vorliegender Erfindung sind die beschichteten Substrate und ein Verfahren zum Aufbringen photographischer Abbildungen auf den Substraten. Die beschichteten Substrate können auch als Aufzeichnungsmaterial für Hologramme (Volumen-Phasen-Diagramm) verwendet werden, wobei vorteilhaft ist, dass für diesen Zweck keine Nassentwicklung notwendig ist.

Die Beschichtung der Substrate kann erfolgen, indem man eine flüssige Zusammensetzung, eine Lösung oder Suspension auf das Substrat aufbringt. Flüssige Zusammensetzungen ohne Lösungsmittel sind bevorzugt. Hierbei kann es zweckmässig sein, die erfindungsgemässen Titanocene in Form eines flüssigen Photoinitiatorengemisches, enthaltend andere Photoinitiatoren, z.B. ein Benzilketal, ein 4-Aroyl-1,3-dioxolan, ein Dialkoxyacetophenon, ein α-Hydroxy-oder α-Aminoacetophenon, ein α-Hydroxycycloalkylphenylketon oder Mischungen hiervon einzusetzen. Besonders vorteilhaft sind flüssige Mischungen aus flüssigen bis festen Photoinitiatoren und flüssigen Titanocenen oder flüssigen Photoinitiatoren und sirupösen bis festen Titanocenen. Diese Gemische bieten anwendungstechnische Vorteile und zeichnen sich durch eine hohe Dunkellagerstabilität aus.

Beispiele für Benzilketale sind solche der Formel

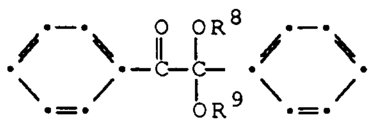

$R^8 = R^9 = -CH_3$

$-CH_2CH_3$

$-(CH_2)_2CH_3$

$-(CH_2)_3CH_3$

$-CH_2CH_2CH(CH_3)_2$

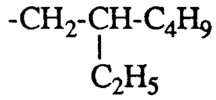

$-(CH_2)_9CH_3$
$-C_{10}H_{21}$-iso
$-C_{12}H_{25}$-n
$-C_9H_{19}$ bis $-C_{11}H_{23}$-Gemisch
$-C_{12}$-$H_{25}$-bis-$C_{15}H_{31}$-Gemisch
$-CH_2CH=CH_2$
$-CH(CH_3)CH=CH_2$
$-CH_2CH_2OC_3H_7$-iso
$-CH_2CH_2OC_4H_9$
$-CH_2CH_2OCH_2CH=CH_2$
$-CH(CH_3)-CH_2OC_4H_9$
$-CH_2COOCH_3$
$-CH_2COOC_4H_9$
$-CH(CH_3)COOCH_3$
$-CH_2CH_2COOC_2H_5$
$-CH(CH_3)CH_2COOCH_3$
$-CH_2CH_2CH(CH_3)OCH_3$

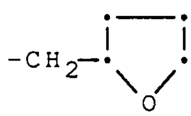

$-(CH_2CH_2O)_2CH_3$
$-(CH_2CH_2O)_2C_2H_5$
$-(CH_2CH_2O)_2C_4H_9$
$-(CH_2CH_2O)_3CH_3$
$-(CH_2CH_2O)_3C_2H_5$
$-(CH_2CH_2O)_3C_{12}H_{25}$
$-(CH_2CH_2O)_5C_{10}H_{21}$
$-(CH_2CH_2O)_8C_9H_{19}$-bis-$C_{11}H_{23}$ (Gemisch)

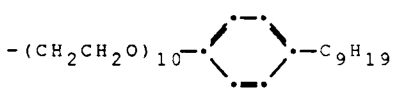

$-CH_2CH_2N(C_2H_5)_2$

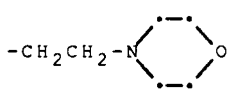

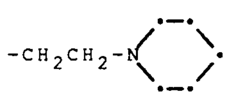

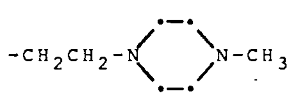

$R^9 = -CH_3$, $R^8 = -C_6H_{13}$
$R^9 = -CH_3$, $R^8 = C_{10}H_{21}$

$R^9$ = $-CH_3$, $R^8$ = $-(CH_2CH_2O)_3-C_{12}H_{25}$ bis-$C_{15}H_{31}$ (Gemisch)
$R^9$ = $-CH_3$, $R^8$ = $-(CH_2CH_2O)_5-C_9H_{19}$ bis-$C_{12}H_{23}$ (Gemisch)
$R^9$ = $-CH_3$,

$$R^8 = -(CH_2CH_2O)_8-\overset{O}{\overset{\|}{C}}-C_{11}H_{23}.$$

Beispiele für 4-Aroyl-1,3-dioxolane sind:
4-Benzoyl-2,2,4-trimethyl-1,3-dioxolan
4-Benzoyl-4-methyl-2,2-tetramethylen-1,3-dioxolan
4-Benzoyl-4-methyl-2,2-pentamethylen-1,3-dioxolan
4-Benzoyl-2,4-dimethyl-2-methoxymethyl-1,3-dioxolan cis-trans
4-Benzoyl-4-methyl-2-phenyl-1,3-dioxolan cis-trans
4-(4-Methoxybenzoyl)-2,2,4-trimethyl-1,3-dioxolan
4-(4-Methoxybenzoyl)-4-methyl-2,2-pentamethylen-1,3-dioxolan
4-(4-Methylbenzoyl)-2,2,4-trimethyl-1,3-dioxolan
4-Benzoyl-2-methyl-4-phenyl-1,3-dioxolan cis-trans
4-Benzoyl-2,2,4,5,5-pentamethyl-1,3-dioxolan
4-Benzoyl-2,2,4,5-tetramethyl-1,3-dioxolan cis-trans
4-Benzoyl-4-methyl-2-pentyl-1,3-dioxolan cis-trans
4-Benzoyl-2-benzyl-2,4-dimethyl-1,3-dioxolan cis-trans
4-Benzoyl-2-(2-furyl)-4-methyl-1,3-dioxolan cis-trans
4-Benzoyl-5-phenyl-2,2,4-trimethyl-1,3-dioxolan cis-trans
4-(4-Methoxybenzoyl)-2,2,4,5,5-pentamethyl-1,3-dioxolan.

Beispiele für Dialkoxyacetophenone sind:
α,α-Dimethoxyacetophenon
α,α-Diethoxyacetophenon
α,α-Di-isopropoxyacetophenon
α,α-Di-(2-methoxyethoxy)acetophenon
α-Butoxy-α-ethoxyacetophenon
α,α-Dibutoxy-4-chloracetophenon
α,α-Diethoxy-4-fluoracetophenon
α,α-Dimethoxy-4-methylacetophenon
α,α-Diethoxy-4-methylacetophenon
α,α-Dimethoxypropiophenon
α,α-Diethoxypropiophenon
α,α-Diethoxybutyrophenon
α,α-Dimethoxyisovalerophenon
α,α-Diethoxy-α-cyclohexylacetophenon
α,α-Dipropoxy-4-chlorpropiophenon.

Beispiele für α-Hydroxy- und α-Aminoacetophenone sind:
2-Hydroxy-2-methyl-1-phenylpropanon-1
2-Hydroxy-2-ethyl-1-phenylhexanon-1
1-(4-Dodecylphenyl)-2-hydroxy-2-methylpropanon-1
1-(2,4-Dimethylphenyl)-2-hydroxy-2-methylpropanon-1
2-Hydroxy-1-(4-methoxyphenyl)-2-methylpropanon-1
2-Hydroxy-2-methyl-1-phenylbutanon-1
2-Dimethylamino-2-methyl-1-phenylpropanon-1
2-Dibutylamino-2-methyl-1-phenylpropanon-1
1-(4-Fluorphenyl)-2-methyl-2-morpholinopentanon-1
2-Methyl-1-(4-methylthiophenyl)-2-morpholinopropanon-1
2-Dimethylamino-1-(4-methoxyphenyl)-2-methylpropanon-1
2-Diethylamino-1-(4-diethylaminophenyl)-2-methylpropanon-1.
2-Benzyl-2-dimethylamino-1-(4-methoxyphenyl)-butanon-1
2-Benzyl-2-dimethylamino-1-(4-tolyl)-butanon-1

2-Benzyl-2-dimethylamino-1-phenylbutanon-1
2-Benzyl-2-dimethylamino-1-(4-chlorphenyl)-butanon-1
2-Benzyl-2-dimethylamino-1-(3,4-dimethoxyphenyl)butanon-1
2-Benzyl-2-dimethylamino-1 (3,4-dimethoxyphenyl)pentanon-1
2-Benzyl-2-dimethylamino-[4-(2-hydroxyethylthio)phenyl]-butanon-1
2-Dimethylamino-2-(4-methylphenylmethyl)-1-(3,4-dimethoxyphenyl)-butanon-1
2-Dimethylamino-2-(4-methylphenylmethyl)-1-(4morpholinophenyl)-butanon-1
2-Benzyl-2-dimethylamino-1-(4-morpholinophenyl)-butanon- 1
2-Benzyl-2-dimethylamino-1-(4-morpholinophenyl)-pentanon-1
2-Benzyl-2-dimethylamino-1-(4-dimethylaminophenyl)-butanon-1
2-Allyl-2-dimethylamino-1-(4-morpholinophenyl)-pent-4-en-1-on
2-Allyl-1-(4-morpholinophenyl)-2-morpholino-pent-4-en-1-on.

Beispiele für α-Hydroxycycloalkylphenylketone sind:
α-Hydroxycyclohexylphenylketon
α-Hydroxycyclopentylphenylketon
Das Photoinitiatorengemisch (b) + (c) kann in Mengen von 0,5-20, vorzugsweise 1 bis 10 Gew.-%, zugegeben werden, bezogen auf die Komponente (a).

Die Wahl des Lösungsmittels und die Konzentration richtet sich hauptsächlich nach der Art der Zusammensetzung und nach dem Beschichtungsverfahren. Die Zusammensetzung wird mittels bekannter Beschichtungsverfahren auf ein Substrat gleichförmig aufgebracht, z.B. durch Tauchen, Rakelbeschichtung, Vorhanggiessverfahren, Elektrophorese, Aufpinseln, Spritzen oder Reverseroll-Beschichtung. Die Auftragsmenge (Schichtdicke) und Art des Substrates (Schichtträger) sind abhängig vom gewünschten Applikationsgebiet. Als Schichtträger für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 µm; für gedruckte Schaltungen im allgemeinen 1 bis ca. 100 µm. Bei Mitverwendung von Lösungsmitteln werden diese nach dem Beschichten entfernt.

Photohärtbare Zusammensetzungen, wie sie für die verschiedenen Zwecke verwendet werden, enthalten meist ausser den photopolymerisierbaren Verbindungen und den Photoinitiatoren eine Reihe sonstiger Zusätze. So ist es vielfach üblich, thermische Inhibitoren zuzusetzen, die vor allem während der Herstellung der Zusammensetzungen durch Mischen der Komponenten vor einer vorzeitigen Polymerisation schützen sollen. Hierzu werden beispielsweise Hydrochinon, Hydrochinonderivate, p-Methoxyphenol, β-Naphthole oder sterisch gehinderte Phenole wie z.B. 2,6-Di(tert-butyl)-p-kresol verwendet. Weiter können geringe Mengen von UV-Absorbern zugesetzt werden, wie z.B. solche vom Benztriazol-, Benzophenon- oder Oxalanilid-Typ. Ebenso lassen sich Lichtschutzmittel vom Typus sterisch gehinderter Amine (HALS) zusetzen.

Zur Erhöhung der Dunkellagerstabitität können Kupferverbindungen, wie Kupfernaphthenat, -stearat, oder -octoat, Phosphorverbindungen, wie Triphenylphosphin, Tributylphosphin, Triethylphosphit, Triphenylphosphit oder Tribenzylphosphit, quaternäre Ammoniumverbindungen, wie Tetramethylammoniumchlorid oder Trimethyl-benzylammoniumchlorid oder Hydroxylaminderivate, wie z.B. N-Diethylhydroxylamin, zugesetzt werden.

Um die inhibierende Wirkung des Luftsauerstoffs auszuschliessen setzt man photohärtbaren Gemischen häufig Paraffin oder ähnliche wachsartige Stoffe zu. Diese schwimmen bei Beginn der Polymerisation wegen mangelnder Löslichkeit im Polymeren aus und bilden eine transparente Oberflächenschicht, die den Zutritt von Luft verhindert.

Weitere übliche Zusätze sind Photosensibilisatoren, welche in bestimmten Wellenlängen absorbieren und die absorbierte Energie an den Initiatoren weitergeben oder selbst als zusätzlicher Initiator fungieren. Beispiele hierfür sind vor allem Thioxanthon-, Anthracen-, Anthrachinon- und Cumarinderivate.

Weitere übliche Zusätze sind Beschleuniger vom Amin-Typ, die vor allem in pigmentierten Zubereitungen von Bedeutung sind, da sie als Kettenüberträger wirken. Beispiele hierfür sind N-Methyldiethanolamin, Triethylamin, p-Dimethylaminobenzoesäureethylester oder Michler' s Keton. Die Wirkung der Amine kann verstärkt werden durch den Zusatz von aromatischen Ketonen vom Benzophenontyp. Weitere übliche Beschleuniger sind 1,3,4-Thiadiazolderivate, wie z.B. 2-Mercapto-5-methylthio-1,3,4-thiadiazol.

Weitere übliche Zusätze sind z.B. Füllstoffe, Pigmente, Farbstoffe, Haft-, Netz- und Verlaufmittel.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare

Druckfarben von Bedeutung.

Gut geeignet sind die erfindungsgemässen photohärtbaren Zusammensetzungen auch zur Herstellung von Druckplatten, insbesondere Flexodruckplatten. Hierbei werden z.B. Gemische von löslichen linearen Polyamiden oder von Styrol-Butadien-Kautschuk mit photopolymerisierbaren Monomeren, beispielsweise Acrylamiden oder Acrylaten, und einem Photoinitiator verwendet. Filme und Platten aus diesen Systemen werden über das Negativ (oder Positiv) der Druckvorlage belichtet und die ungehärteten Anteile anschliessend mit einem Lösungsmittel eluiert.

Ein weiteres Einsatzgebiet der Photohärtung ist die Metallbeschichtung, beispielsweise bei der Lackierung von Blechen für Tuben, Dosen oder Flaschenverschlüsse, sowie die Photohärtung von Kunststoffbeschichtungen, beispielsweise von Fussboden-oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung der photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösungsmittel (= Entwickler) entfernt. Die belichteten Stellen sind vernetztpolymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Die erfindungsgemässen Titanocene können auch als Photoinitiatoren in lichthärtbaren Zusammensetzungen für Dentalapplikationen verwendet werden. Sie liefern mit kurzen Bestrahlungenszeiten Materialien von hoher Festigkeit und einem geringen Grad an restlichen ungesättigten Komponenten. Durch Belichten von dentalen Zusammensetzungen, basierend auf olefinischen ungesättigten Harzen, anorganischen Füllern und Titanocen-Photoinitiatoren, lassen sich mit kommerziellen Lichtquellen für Dentalapplikationen innerhalb von wenigen Sekunden Härtungstiefen von einigen Millimetern erreichen. Beispiele für Zusammensetzungen von Dentalmassen, die mit erfindungsgemässen Verbindungen gehärtet werden können, sowie nähere Details über Bindemittel, Füllstoffe, weitere Zusätze und Applikationsverfahren sind z.B. der EP-A 334 338 und der DE-A 3 801 511 zu entnehmen.

Zur Belichtung eignen sich Lichtquellen mit hohem Anteil an kurzwelligem Licht. Hierfür stehen heute entsprechende technische Vorrichtungen und verschiedene Lampenarten zur Verfügung. Beispiele sind Kohlelichtbogenlampen, Xenonlichtbogenlampen, Quecksilberdampflampen, Metall-Halogenlampen, Fluoreszenzlampen, Argonlampen oder photographische Flutlichtlampen. Neuerdings werden auch Laserlichtquellen verwendet. Diese haben den Vorteil, dass keine Photomasken notwendig sind; der gesteuerte Laserstrahl schreibt direkt auf die photohärtbare Schicht.

Die nachfolgenden Beispiele erläutern die Erfindung näher.

A) Herstellung von Hydroxyaryltitanocenen

Beispiel 1: Bis(cyclopentadienyl)-bis(2,6-difluor-3-hydroxyphenyl)-titan

1a) 1-Trimethylsiloxy-2,4-difluorbenzol

In einen 2,5 l Sulfierkolben werden 260,2 g (2,0 Mol) 2,4-Difluorphenol und 242,9 g (2,4 Mol) Triethylamin in 700 ml Dichlormethan gelöst und auf 0 °C abgekühlt. Während ca. 3 Stunden werden 239 g (2,2 Mol) Trimethylchlorsilan zugetropft. Die weisse Suspension lässt man 8 Stunden ausreagieren (Kontrolle mit GC und DC). Die Suspension wird filtriert, der Rückstand mit wenig Dichlormethan nachgewaschen und das Filtrat am Rotationsverdampfer eingeengt. Das erhaltene Oel wird bei 56-62 °C im Vacuum (22 mbar) destilliert. Man erhält 280 g einer Klaren farblosen Flüssigkeit.

| Analyse: $C_9H_{12}F_2OSi$ (202,28) | | | | |
|---|---|---|---|---|
| berechnet: | 53,44 % C | 5,98 % H | 18,79 % | F 13,89 % Si |
| gefunden: | 53,3 % C | 6,O % H | 18,7 % | F 14,1 % Si |

1b) Bis(cyclopentadienyl)-bis(2,6-difluor-3-hydroxyphenyl)-titan

In einem Sulfierkolben werden unter Stickstoff als Schutzgas 18,2 g (O,O73 Mol) Bis(cyclopentadienyl)-titandichlorid und 34,4 g (O,17 Mol) 1-Trimethylsiloxy-2,4-difluorbenzol in 25 ml absolutem Tetrahydrofuran vorgelegt. Die Suspension wird auf -10 °C gekühlt. Nun wird in 30 Minuten bei -10° bis O °C eine Lösung von Lithiumdiisopropylamid zugetropft, hergestellt aus 16,2 g (O,16 Mol) Diisopropylamin in 25 ml absolutem Teträhydrofuran und 100 ml (O,16 Mol) Butyllithiumiösung in Hexan (1,6 molare Hexanlösung). Dann wird eine Stunde bei O °C nachgerührt, auf Raumtemperatur erwärmt und unter Lichtschutz am Rotationsverdampfer eingeengt (Umsatzkontrolle mit GC). Der Rückstand wird in 100 ml Dichlormethan angerührt und über Kieselerde filtriert. Das Filtrat wird erneut am Rotationsverdampfer eingeengt. Der Rückstand wird in 200 ml Dioxan-Wasser-Gemisch (3:1) gelöst, mit 18,4 g (O,14 Mol) Oxalsäure-Dihydrat versetzt und eine Stunde bei Raumtemperatur gerührt. Dann wird mit 300 ml Wasser verdünnt. Die orange Suspension wird filtriert und der Rückstand mit Wasser nachgewaschen und im Trockenschrank bei 35-40 °C im Vacuum getrocknet.

Man erhält 24,9 g eines orangen Pulvers vom Schmelzpunkt 212-216 °C.

| Analyse: $C_{22}H_{16}F_4O_2Ti$ (436,26) | | | | |
|---|---|---|---|---|
| berechnet: | 60,57 % C | 3,70 % H | 17,42 % F | 10,98 % Ti |
| gefunden: | 60,50 % C | 3,86 % H | 17,19 % F | 10,9 % Ti |

Beispiel 2: Bis(cyclopentadienyl)-bis(2,3,5,6-tetrafluor-4-hydroxyphenyl)-titan

2a) 1-Trimethylsiloxy-2,3,5,6-tetrafluorbenzol

In einem Sulfierkolben werden 124,6 g (O,75 Mol) 2,3,5,6-Tetrafluorphenol in 200 ml absolutem Acetonitril gelöst. Dann werden bei Raumtemperatur unter Kühlung zuerst 64,6 g (O,40 Mol) Hexamethyldisilazan zugetropft und anschliessend noch 43,5 g (O,40 Mol) Trimethylchlorsilan langsam zugetropft. Dann wird zwei Stunden bei Raumtemperatur nachgerührt. Die entstandene Fällung von Ammoniumchlorid wird abfiltriert und mit Acetonitril gewaschen. Die vereinigten Filtrate werden am Vacuumrotationsverdampfer bei 20 °C und 19 mbar Druck eingeengt und der Rückstand wird bei 16 mbar Druck destilliert. Man erhält 140,8 g eines farblosen Oels, das bei 16 bis 18 mbar und einer Temperatur von 63-64 °C siedet.

| Analyse: $C_9H_{10}F_4OSi$ (238,26) | | | | |
|---|---|---|---|---|
| berechnet: | 45,37 % C | 4,23 % H | 31,90 % F | 11,79 % Si |
| gefunden: | 45,4 % C | 4,2 % H | 31,8 % F | 11,9 % Si |

2b) Bis(cyclopentadienyl)-bis(2,3,5,6-tetrafluor-4-hydroxyphenyl)-titan

In einem Sulfierkolben werden unter Stickstoff als Schutzgas 600 ml absoluter Diethylether, 81,0 g (O,80 Mol) Diisopropylamin und 6,66 g (0,96 Mol) fein geschnittener Lithium-Draht bei 35 °C vorgelegt. Hierauf wird ein Gemisch aus 83,3 g (O,80 Mol) monomerem Styrol und 8OO ml absolutem Diethylether zugetropft. Die Temperatur wird anschliessend weiter bei 35 °C gehalten, bis das Lithiummetall in Lösung ist. Darauf wird auf -75 °C abgekühlt und dann langsam eine Lösung von 190,6 g (O,80 Mol) 1-Trimethylsiloxy-2,3,5,6-tetrafluorbenzol in 450 ml absolutem Cyclohexan zugetropft. Es wird eine Stunde bei -70 °C nachgerührt. Dann werden 99,6 g (O,40 Mol) fein pulverisiertes Bis(cyclopentadienyl)-titandichlorid zugegeben. Das Reaktionsgemisch wird vor Licht geschützt und die Temperatur lässt man langsam über Nacht auf Raumtemperatur steigen. Dann wird das Reaktionsgemisch filtriert. Der Rückstand wird mit Diethylether nachgewaschen. Das Filtrat wird am Vacuumrotationsverdampfer unter Lichtausschluss eingeengt. Man erhält ein orangerotes Harz. Das Rohprodukt wird in 500 ml Methanol gelöst, mit 20 ml Wasser und O,1 g Toluol-4-sulfonsäure versetzt und während zwei Stunden auf 45 °C erwärmt. Nach dem Erkalten fällt über Nacht ein orange-roter Niederschlag aus, der abfiltriert und mit Ethanol gewaschen wird. Man erhält 181 g Produkt, das bei 174-178 °C unter Zersetzung schmilzt.

Beispiel 3: Bis(cyclopentadienyl)-bis(2,6-difluor-3-hydroxyphenyl)-titan

3a) 2-(2,4-Difluorphenoxy)-tetrahydro-2H-pyran

In einem 750 ml Sulfierkolben werden 260,2 g (2,0 Mol) 2,4-Difluorphenol und 252,4 g (3,0 Mol) 3,4-Dihydro-2H-pyran vorgelegt und auf 0 °C gekühlt. Zur Lösung wird vorsichtig ein Tropfen Polyphosphorsäure zugegeben und 16 Stunden bei O bis 5 °C nachgerührt (Kontrolle mit GC und DC). Dann wird mit wenig pulverisiertem Natriumhydroxid alkalisch gestellt. Das Produkt wird bei 119-120 °C im Vacuum (22 mbar) destilliert. Man erhält 377 g (88 % der Theorie) einer Klaren, farblosen Flüssigkeit.

| Analyse: $C_{11}H_{12}F_2O_2$ (214,21) | | |
|---|---|---|
| berechnet:<br>gefunden: | 61,68 % C<br>62,06 % C | 5,65 % H<br>6,01 % H |

3b) Bis(cyclopentadienyl)-bis(2,6-difluor-3-hydroxyphenyl)-titan

In einem Sulfierkolben werden unter Stickstoff als Schutzgas 101,2 g (1,0 Mol) Diisopropylamin in 300 ml absolutem Tetrahydrofuran vorgelegt und auf -70 °C abgekühlt. Dann werden 625 ml (1,0 Mol) Butyllithiumlösung in Hexan (1,6 molare Hexanlösung) in ca. 2 Stunden zugetropft und eine Stunde bei -70 °C nachgerührt. Nun werden 214,2 g (1,0 Mol) 2-(2,4-Difluorphenoxy)-tetrahydro-2H-pyran, verdünnt mit 60 ml absolutem Tetrahydrofuran, in einer Stunde zugetropft. Danach werden 300 ml absoluter Ether und anschliessend 113,2 g (O,455 Mol) Bis(cyclopentadienyl)titandichlorid zugegeben. Es wird noch 30 Minuten bei -70 °C nachgerührt. Dann lässt man die Temperatur innerhalb 10 Stunden auf Raumtemperatur steigen. Das Reaktionsgemisch wird am Rotationsverdampfer eingeengt und der Rückstand in Dichlormethan angerührt und über Kieselerde filtriert. Das Filtrat wird erneut am Rotationsverdampfer eingeengt. Der Rückstand wird in 11OO ml Dioxan-Wasser-Gemisch (3:1) gelöst, mit 114,6 g (O,91 Mol) Oxalsäure-Dihydrat versetzt und eine Stunde bei Raumtemperatur gerührt. Dann wird mit 1000 ml Wasser verdünnt. Die orange Suspension wird filtriert und der Rückstand mit Wasser nachgewaschen und im Trockenschrank: bei 35-40 °C im Vacuum getrocknet. Man erhält 160,1 g der Titelverbindung als orangerotes Pulver, das bei 212-216 °C schmilzt und identisch ist mit dem Produkt des Beispiels 1.

B) Umwandlungen von Hydroxyaryltitanocenen

Beispiel 4: Bis(cyclopentadienyl)-bis(2,6-difluor-3-acetoxyphenyl)-titan

In einen 100 ml Sulfierkolben werden unter Stickstoff als Schutzgas 8,7 g (O,O20 Mol) Bis-(cyclopentadienyl)-bis(2,6-difluor-3-hydroxyphenyl)-titan und 3,8 g (O,O48 Mol) Pyridin in 30 ml Toluol-DMF-Gemisch (1:1) vorgelegt. Zu dieser Lösung werden bei Raumtemperatur in 5 Minuten 4,9 g (O,O48 Mol) Essigsäureanhydrid zugetropft und während 24 Stunden nachgerührt (Reaktionskontrolle mit Dünnschichtchromatogramm).Dann wird das Reaktionsgemisch auf Ether und Wasser gegossen. Die Etherphase wird abgetrennt, dreimal mit Wasser gewaschen, mit Magnesiumsulfat getrocknet und am Rotationsverdampfer eingeengt. Der Rückstand wird durch Flashchromatographie mit Hexan-Ether-Gemisch 1:1 gereinigt und nach dem Einengen aus einem Ether-Hexan-Gemisch kristallisiert. Man erhält 7,7 g eines gelben Pulvers vom Schmelzpunkt 104-123 °C (Zersetzung).

| Analyse: $C_{26}H_{20}F_4O_4Ti$ (520,34). | | |
|---|---|---|
| berechnet:<br>gefunden: | 60,02 % C<br>58,97 % C | 3,87 % H<br>4,22 % H |

Beispiel 5: Bis(cyclopentadienyl)-bis(2,6-difluor-3-propionyloxyphenyl)-titan

Die Verbindung wird analog Beispiel 4 hergestellt unter Verwendung von Propionsäureanhydrid. Das Produkt wird als glasige Substanz erhalten.

| Analyse: $C_{28}H_{24}F_4O_4Ti$ (548,39) | | |
|---|---|---|
| berechnet: | 61,33 % C | 4,41 % H |
| gefunden: | 60,72 % C | 4,52 % H |

Beispiel 6: Bis(cyclopentadienyl)-bis(2,6-difluor-3-decanoyloxyphenyl)-titan

In einem 100 ml Sulfierkolben werden unter Stickstoff als Schutzgas 6,1 g (0,014 Mol) Bis-(cyclopentadienyl)-bis(2,6-difluor-3-hydroxyphenyl)-titan und 2,7 g (O,O336 Mol) Pyridin in 50 ml Toluol-DMF-Gemisch (1:1) vorgelegt. Zu dieser roten Lösung werden bei Raumtemperatur in 5 Minuten 6,4 g (O,O336 Mol) Decanoylchlorid zugetropft und während 16 Stunden nachgerührt (Reaktionskontrolle mit Dünnschichtchromatogramm).Dann wird das Reaktionsgemisch auf Ether und Wasser gegossen. Die Etherphase wird abgetrennt, zweimal mit Wasser gewaschen, mit Magnesiumsulfat getrocknet und am Rotationsverdampfer eingeengt. Der Rückstand wird durch Flashchromatographie, mit Hexan-Ether-Gemisch 9:1 als Laufmittel, gereinigt und am Rotationsverdampfer eingeengt. Man erhält 6,9 g eines roten Klaren Harzes.

| Analyse: $C_{42}H_{52}F_4O_4Ti$ (744,77) | | |
|---|---|---|
| berechnet: | 67,73 % C | 7,04 % H |
| gefunden: | 67,74 % C | 7,11 % H |

Beispiel 7: Bis(cyclopentadienyl)-bis(2,6-difluor-3-stearoyloxyphenyl)-titan

Die Verbindung wird analog Beispiel 6 hergestellt unter Verwendung von Stearoylchlorid. Das Produkt wird als orangerotes Pulver erhalten, das bei 77-78 ° C schmilzt.

| Analyse: $C_{58}H_{84}F_4O_4Ti$ (969,20) | | |
|---|---|---|
| berechnet: | 72,O3 % C | 8,55 % H |
| gefunden: | 71,37 % C | 8,72 % H |

Beispiel 8: Bis(cyclopentadienyl)-bis(2,6-difluor-3-methacryloyloxyphenyl)-titan

Die Verbindung wird analog Beispiel 6 hergestellt unter Verwendung von Methacryloylchlorid. Das Produkt wird als orangerotes Pulver erhalten, das bei 226-228 ° C schmilzt.

| Analyse: $C_{30}H_{24}F_4O_4Ti$ (572,41) | | | |
|---|---|---|---|
| berechnet: | 62,94 % C | 4,22 % H | 13,27 % F |
| gefunden: | 63,20 % C | 4,62 % H | 12,50 % F |

Beispiel 9: Bis(cyclopentadienyl)-bis[2,6-difluor-3-(isopropylaminocarbonyloxy)-phenyl]-titan

In einem 100 ml Sulfierkolben werden unter Stickstoff als Schutzgas 8,7 g (O,O20 Mol) Bis-(cyclopentadienyl)-bis(2,6-difluor-3-hydroxyphenyl)titan, 4,1 g (O,O48 Mol) Isopropylisocyanat und O,6 g (O,OO6 Mol) Triethylamin (als Katalysator) in 50 ml 1,2-Dichlorethan unter Rückfluss (ca. 83 ° C) erwärmt. Nach 12 Stunden Rühren am Rückfluss ist bei einer Reaktionskontrolle mit Dünnschichtchromatographie die Reaktion beendet. Das Reaktionsgemisch wird am Vacuumrotationsverdampfer eingeengt und mittels Flashchromatographie mit einem Hexan-Ether-Gemisch 1:1 gereinigt und erneut am Rotationsverdampfer eingeengt. Man erhält 7,0 g eines glasartigen orangen Pulvers.

| Analyse: $C_{30}H_{30}F_4N_2O_4Ti$ (606,47) | | | |
|---|---|---|---|
| berechnet: | 59,41 % C | 4,99 % H | 4,62 % N |
| gefunden: | 58,6 % C | 5,4 % H | 4,6 % N |

Beispiel 10: Bis(cyclopentadienyl)-bis[2,6-difluor-3-(butylaminocarbonyloxy)-phenyl]-titan

Die Verbindung wird analog Beispiel 9 hergestellt unter Verwendung von Butylisocyanat und wird als glasartiges orangerotes Pulver erhalten.

| Analyse: $C_{32}H_{34}F_4H_2O_4Ti$ (634,53) | | | |
|---|---|---|---|
| berechnet: | 60,57 % C | 5,40 % H | 4,41 % N |
| gefunden: | 58,64 % C | 5,18 % H | 3,76 % N |

Beispiel 11: Bis(cyclopentadienyl)-bis[2,6-difluor-3-(isobutyloxycarbonyloxy)-phenyl]-titan

In einem 100 ml Sulfierkolben werden unter Stickstoff 8,7 g (O,O20 Mol) Bis(cyclopentadienyl)-bis(2,6-difluor-3-hydroxyphenyl)-titan, 3,8 g (0,O48 Mol) Pyridin und eine Kleine Spatelspitze 4-Dimethylaminopyridin als Katalysator in 20 ml Dimethylformamid und 30 ml Toluol gelöst. In diese dunkelrote Lösung werden bei Raumtemperatur 6,6 g (O,O48 Mol) Chlorameisensäureisobutylester in 10 Minuten zugetropft. Das Reaktionsgemisch wird über Nacht bei Raumtemperatur gerührt, bis im Dünnschichtchromatogramm kein Edukt mehr erscheint. Die Suspension wird auf 100 ml Essigester und 100 ml Wasser gegossen, verrührt und über Hyflo filtriert. Die beiden Phasen des Filtrates werden voneinander getrennt. Die organische Phase wird mit Magnesiumsulfat getrocknet, filtriert und im Vacuumrotationsverdampfer bei 20 mbar und 40 °C Badtemperatur eingeengt. Man erhält ein dunkelrotes Oel, das durch Flashchromatographie mit Hexan-Essigester (3:1) als Lösungsmittel gereinigt wird. Man erhält 6,6 g (52 % der Theorie) eines orangeroten glasigen Harzes.

| Analyse: $C_{32}H_{32}F_4O_6Ti$ (636,49) | | |
|---|---|---|
| berechnet: | 60,39 % C | 5,07 % H |
| gefunden: | 60,1 % C | 5,3 % H |

Beispiel 12: Bis(cyclopentadienyl)-bis[2,6-difluor-3(4-tolylsulfonyloxy)phenyl]-titan

In einem Sulfierkolben werden unter Stickstoff als Schutzgas 4,4 g (O,O10 Mol) Bis(cyclopentadienyl)-bis(2,6-difluor-3-hydroxyphenyl)-titan in 100 ml Toluol suspendiert. Dann werden 5,7 g (O,O30 Mol) Toluol-4-sulfochlorid zugegeben. Anschliessend lässt man 30 ml 1N Natronlauge (O,O30 Mol) zutropfen. Die Reaktion ist schwach exotherm und die Temperatur des Reaktionsgemisches steigt allmählich auf 40 °C. Es wird 3 Stunden bei fallender Temperatur nachgerührt (Dünnschichtkontrolle der Reaktion). Dann werden 100 ml Eiswasser und 100 ml Ether zugegeben. Die organische Phase wird abgetrennt und mehrmals mit wenig Wasser gewaschen, bis das Waschwasser neutral ist. Die organische Phase wird mit Magnesiumsulfat getrocknet und am Vacuumrotationsverdampfer eingeengt. Es hinterbleibt ein oranges Produkt, das nach der chromatographischen Reinigung an Kieselgel mit Toluol als Laufmittel orange Kristalle mit einem Schmelzpunkt von 185-187 °C ergibt.

| Analyse: $C_{36}H_{28}F_4O_6S_2Ti$ (744,6) | | | | |
|---|---|---|---|---|
| berechnet: | 58,07 % C | 3,79 % H | 10,21 % F | 8,61 % S |
| gefunden: | 58,1 % C | 3,8 % H | 10,3 % F | 8,5 % S |

Beispiel 13: Bis(cyclopentadienyl)-bis[2,3,5,6-tetrafluor-4-(4-tolyl-sulfonyloxy)-phenyl]-titan

In einem Sulfierkolben werden unter Stickstoff als Schutzgas 5,1 g (O,O10 Mol) Bis(cyclopentadienyl)-bis(2,3,5,6-tetrafluor-4-hydroxyphenyl)-titan in 100 ml Toluol suspendiert. Dann werden 5,7 g (O,O30 Mol) Toluol-4-sulfochlorid zugegeben. Anschliessend lässt man 40 ml 1N Natronlauge (O,040 Mol) zutropfen und vier Stunden bei 40 °C rühren. Nach einer Kontrolle der Reaktion mit Dünnschichtchromatographie lässt man erkalten. Dann werden 100 ml Eiswasser und 100 ml Ether zugesetzt. Die organische Phase wird abgetrennt und mit wenig Wasser mehrmals gewaschen, bis die Reaktion auf dem pH-Papier neutral ist. Die organische Phase wird mit Magnesiumsulfat getrocknet und am Vacuumrotationsverdampfer eingeengt. Es hinterbleibt ein orangerotes kristallines Produkt, das nach einer Umkristallisation aus Toluol bei 226-228 °C schmilzt.

| Analyse: $C_{36}H_{24}F_8O_6S_2Ti$ (816,60) | | | | |
|---|---|---|---|---|
| berechnet:<br>gefunden: | 52,95 % C<br>53,O % C | 2,96 % H<br>3,O % H | 7,85 % S<br>8,2 % S | 18,61 % F<br>18,5 % F |

Beispiel 14: Bis(cyclopentadienyl)-bis[2,6-difluor-3-(dimethyl-(1,1,2-trimethylpropyl)siloxy)-phenyl]-titan

In einem Kleinen Kolben werden 6,1 g (O,O14 Mol) Bis(cyclopentadienyl)-bis(2,6-difluor-3-hydroxyphenyl)-titan in 50 ml Toluol suspendiert. Die Suspension wird auf O° bis 5 °C abgekühlt und dann werden 1,7 g (O,O17 Mol) Triethylamin zugegeben. Anschliessend lässt man 3,0 g (O,O17 Mol) Dimethyl-(1,1,2-trimethylpropyl)chlorsilan zutropfen. Es tritt zuerst keine Reaktion ein. Nun lässt man 15 ml Dimethylformamid zutropfen, bis alles gelöst ist. Die Lösung wird über Nacht bei Raumtemperatur gerührt. Am nächsten Tag ist die Reaktion beendet (DC-Kontrolle). Das Reaktionsgemisch wird mit Ether und Wasser versetzt. Die organische Phase wird abgetrennt, zweimal mit Wasser und zweimal mit 5 %iger Natronlauge gewaschen, mit $Na_2SO_4$ getrocknet, filtriert und am Vacuumrotationsverdampfer eingeengt. Das rote Oel wird mittels Flashchromatographie mit einem Hexan-Ether-Gemisch (1:1) gereinigt. Man erhält 9,1 g eines gelborangen Harzes, das langsam kristallisiert. Eine Umkristallisation aus Ethanol gibt gelbe Kristalle mit einem Schmelzpunkt von 112-115 °C.

| Analyse: $C_{38}H_{52}F_4O_2Si_2Ti$ (720,90) | | | |
|---|---|---|---|
| berechnet:<br>gefunden: | 63,31 % C<br>63,75 % C | 7,27 % H<br>7,60 % H | 10,54 % F<br>10,03 % F |

C) Direkte Herstellung der substituierten Titanocene

Beispiel 15: Bis(cyclopentadienyl)-bis[2,6-difluor-3-(trimethylsiloxy)-phenyl]-titan

In einem Dreihalskolben werden unter Stickstoff als Schutzgas 16,2 g (0,16 Mol) Diisopropylamin und 25 ml absolutes Tetrahydrofuran vorgelegt und auf 0 °C gekühlt. Dazu gibt man tropfenweise 100 ml (O,16 Mol) Butyllithiumlösung in Hexan (1,6 molare Hexanlösung). Die entstandene gelbe Lösung von Lithiumdiisopropylamid wird anschliessend 10 Minuten bei O °C gerührt und dann zu einer Suspension aus 18,2 g (O,O73 Mol) Bis-(cyclopentadienyl)-titandichlorid und 34,4 g (0,17 Mol) Trimethylsiloxy-2,4-difluorbenzol in 25 ml absolutem Tetrahydrofuran bei - 10° bis 0 °C während 30 Minuten zugetropft. Die Suspension wird eine Stunde bei O °C nachgerührt. Dann wird das Lösungsmittel am Vacuumrotationsverdampfer entfernt. Der Rückstand wird in 100 ml Dichlormethan angerührt und über Kieselerde filtriert. Das Filtrat wird am Vacuumrotationsverdampfer erneut eingeengt. Man erhält ein oranges Oel, das man aus Hexan bei -20 °C kristallisieren kann. Der Schmelzpunkt ist unter 20 °C.

| Analyse: $C_{28}H_{32}F_4O_2Si_2Ti$ (580,62) | | |
|---|---|---|
| berechnet:<br>gefunden: | 57,92 % C<br>57,87 % C | 5,55 % H<br>5,49 % H |

D) Anwendungsbeispiele

Beispiel 16: Photohärtung eines Acrylat-Gemisches Es wird eine photohärtbare Zusammensetzung hergestellt durch Mischen der folgenden Komponenten:

| | Feststoffgehalt |
|---|---|
| 150,30 g Scripset 540[1)] (30 %-ige Lsg. in Aceton)<br>48,30 g Trimethylolpropantriacrylat<br>6,60 g Polyethylenglykoldiacrylat<br>0,08 g Kristallviolett | 45,1 g<br>48,3 g<br>6,6 g |
| 205,28g | 100,0g |

1) Polystyrol-Maleinsäureanhydrid-Copolymer (Monsanto)

Portionen dieser Zusammensetzung werden mit jeweils 0,3 % (bezogen auf den Feststoffgehalt) an Photoinitiator vermischt. Alle Operationen werden unter Rotlicht oder Gelblicht ausgeführt.

Die mit Initiator versetzten Proben werden in einer Stärke von 150 µm auf 200 µm Aluminiumfolie (10 x 15 cm) aufgetragen. Das Lösungsmittel wird durch Erwärmung auf 60 °C während 15 Minuten im Umluftofen entfernt. Auf die flüssige Schicht wird eine 76 µm dicke Polyesterfolie gelegt und auf diese ein standardisiertes Testnegativ mit 21 Stufen verschiedener optischer Dichte (Stouffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 10 Sekunden, einer zweiten Testreihe 20 Sekunden und einer dritten Testreihe 40 Sekunden. Nach der Belichtung werden die Folien und die Maske entfernt, die belichtete Schicht in einem Ultraschallbad 120 Sekunden mit Entwickler A entwickelt und anschliessend bei 60 °C 15 Minuten im Umluftofen getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 1 angegeben. Entwickler A enthält 15 g Natriummetasilikat•$9H_2O$; 0,16 g KOH; 3 g Polyethylenglykol 6000; 0,5 g Lävulinsäure und 1000 g deionisiertes Wasser.

**Tabelle 1:**

| Titanocen Beispiel | Zahl der abgebildeten Stufen nach 10 s | 20 s | 40s Belichtung |
|---|---|---|---|
| 6 | 13 | 16 | 19 |
| 7 | 13 | 15 | 18 |
| 8 | 12 | 15 | 17 |
| 9 | 10 | 13 | 15 |
| 11 | 10 | 13 | 17 |
| 12 | 13 | 16 | 18 |
| 13 | 12 | 15 | 18 |

Beispiel 17: Photohartung eines Monomer-Polymer-Gemisches

Es wird eine photohärtbare Zusammensetzung hergestellt durch Mischen der folgenden Komponenten:

37,64 g Sartomer SR 444 (Pentaerythritol-triacrylat) (Sartomer Company, Westchester)
10,76 g Cymel 301 Hexamethoxymethylmelamin (Cyanamid)
47,30 g Carboset 525 (Thermoplastisches Polyacrylat mit Carboxylgruppen/B.F. Goodrich)
4,30 g Polyvinylpyrrolidon PVP (GAF)
100,00 g der obigen Mischung
0,50g Irgalitgrün GLN
319,00 g Methylenchlorid
30,00 g Methanol
450,00g

Portionen dieser Zusammensetzung werden mit jeweils 0,3 % (bezogen auf Feststoff der in der folgenden Tabelle angegebenen Titanocene vermischt. Alle Operationen werden unter Rotlicht oder Gelblicht ausgeführt.

Die mit Initiator versetzten Proben werden in einer Stärke von 200 µm auf 200 µm Aluminiumfolie (10 x 15 cm) aufgetragen. Das Lösungsmittel wird durch Erwärmung auf 60°C während 15 Minuten im Umluftofen entfernt. Auf die flüssige Schicht wird eine 76 µm dicke Polyesterfolie gelegt und auf diese ein standardisiertes Testnegativ mit 21 Stufen verschiedener optischer Dichte (Stouffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 10 Sekunden, in einer zweiten Testreihe 20 Sekunden und in einer dritten Testreihe 40 Sekunden. Nach der Belichtung werden die Folien und die Maske entfernt, die belichtete Schicht in einem Ultraschallbad 240 Sekunden mit Entwickler A entwickelt und anschliessend bei 60°C 15 Min. im Umluftofen getrocknet. Die Empfindlichkeit des verwendeten Initiatorsystems wird durch die Angabe der letzten Klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 2 angegeben.

Tabelle 2:

| Titanocen Beispiel | Zahl der abgebildeten Stufen nach 10 s | 20 s | 40s Belichtung |
|---|---|---|---|
| 6 | 13 | 15 | 18 |
| 7 | 13 | 15 | 17 |
| 8 | 11 | 14 | 16 |
| 9 | 11 | 14 | 17 |
| 11 | 11 | 14 | 17 |

**Patentansprüche**

**1.** Titanocene der Formel I

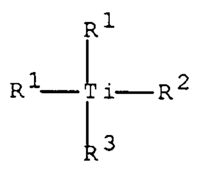

(I),

worin beide $R^1$ unabhängig voneinander gegebenenfalls ein- oder mehrfach durch $C_1$-$C_{18}$-Alkyl oder -Alkoxy, $C_2$-$C_{18}$-Alkenyl, $C_5$-$C_8$-Cycloalkyl, $C_6$-$C_{10}$-Aryl, $C_7$-$C_{16}$-Aralkyl, $-Si(R^4)_3$, $-Ge(R^4)_3$, Cyano oder Halogen substituiertes Cyclopentadienyl$^{\ominus}$, Indenyl$^{\ominus}$ oder 4,5,6,7-Tetrahydroindenyl$^{\ominus}$ bedeuten und $R^4$

$C_1$-$C_{12}$-Alkyl, $C_5$-$C_8$-Cycloalkyl, $C_6$-$c_{10}$-Aryl oder $C_7$-$C_{16}$-Aralkyl bedeutet, $R^2$ einen 6-gliedrigen carbocyclischen oder 5- oder 6-gliedrigen heterocyclischen aromatischen Ring bedeutet, der mindestens in den beiden ortho-Stellungen zur Titankohlenstoffbindung mit Fluoratomen substituiert ist und wobei der aromatische Ring weitere Substituenten enthalten kann, $R^3$ unabhängig die Bedeutung von $R^2$ hat, wobei die Titanocene dadurch gekennzeichnet sind, dass $R^2$ und $R^3$ durch einen Rest der Formel II substituiert sind,

-O-Y-$R^5$ II

worin Y eine Gruppe -CO-, -CS-, -CO-O-, -$SO_2$-, -Si($R^4$)$_2$-, -CO-$NR^6$-, -CS-$NR^6$- oder -$SO_2$-$NR^6$- ist, $R^5$ lineares oder verzweigtes $C_1$-$C_{20}$-Alkyl, $C_2$-$C_{20}$-Alkenyl, $C_3$-$C_8$-Cycloalkyl, $C_4$-$C_{20}$-Cycloalkylalkyl, $C_4$-$C_{20}$-Alkylcycloalkyl, $C_5$-$C_{20}$-Alkylcycloalkylalkyl, $C_6$-$C_{20}$-Cycloalkenylalkyl, $C_7$-$C_{20}$-Bicycloalkyl, $C_6$-$C_{14}$-Aryl, $C_7$-$C_{12}$-Aralkyl, $C_7$-$C_{20}$-Alkylaryl oder $C_8$-$C_{20}$-Alkylaralkyl bedeutet, wobei diese Reste unsubstituiert oder durch $C_1$-$C_{18}$-Alkoxy, $C_1$-$C_{12}$-Alkylthio, $C_1$-$C_{18}$-Alkylsulfonyl, $C_6$-$C_{10}$-Arylsulfonyl, $C_7$-$C_{20}$-Alkylarylsulfonyl, -COOH, -CN, -$COOR^4$, -CO-($C_1$-$C_{20}$-Alkyl) oder Halogen substituiert sind, $R^6$ Wasserstoff ist oder eine der für $R^5$ genannten Bedeutungen hat oder $R^5$ und $R^6$ zusammen $C_3$-$C_7$-Alkylen bedeuten, das durch -O-, -S- oder - N($R^7$)- unterbrochen sein kann, worin $R^7$ Wasserstoff, $C_1$-$C_{12}$-Alkyl, $C_3$-$C_{12}$-Alkenyl, $C_7$-$C_{12}$-Aralkyl oder $C_2$-$C_{20}$-Alkanoyl bedeutet.

**2.** Titanocene gemäss Anspruch 1, dadurch gekennzeichnet, dass $R^1$ Cyclopentadienyl$^{\ominus}$ oder Methylcyclopentadienyl$^{\ominus}$, insbesondere Cyclopentadienyl$^{\ominus}$, ist.

**3.** Titanocene gemäss Anspruch 1, dadurch gekennzeichnet, dass $R^2$ und $R^3$ die gleiche Bedeutung haben.

**4.** Titanocene gemäss Anspruch 1, dadurch gekennzeichnet, dass $R^2$ und $R^3$ für 2,6-Difluorphen-1-yl stehen, an das ein Rest der Formel II gebunden ist, und das weitere 1 oder 2 gleiche oder verschiedene Substituenten enthalten kann.

**5.** Titanocene gemäss Anspruch 1, dadurch gekennzeichnet, dass $R^2$ und $R^3$ eine Gruppe der Formel III sind,

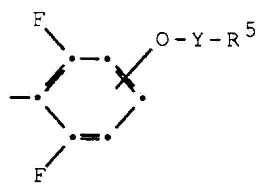

III ,

worin Y und $R^5$ die in Anspruch 1 gegebenen Bedeutungen haben.

**6.** Titanocene gemäss Anspruch 1, dadurch gekennzeichnet, dass $R^2$ und $R^3$ Reste der Formel IV sind,

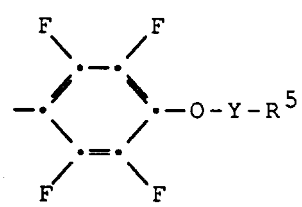

IV

worin Y und $R^5$ die in Anspruch 1 gegebenen Bedeutungen haben.

**7.** Titanocene gemäss Anspruch 1, dadurch gekennzeichnet, dass $R^2$ und $R^3$ eine Gruppe der Formel III oder IV sind, worin Y -CO-, -CO-O-, -$SO_2$-, -CO-$NR^6$-, -CS-NH- oder -$SO_2NR^6$- bedeutet, $R^5$ $C_1$-$C_{12}$-

Alkyl, Cyclohexyl, $C_2$-$C_5$-Alkenyl, Cyclohexylmethyl, $C_7$-$C_{12}$-Aralkyl, $C_6$-$C_{10}$-Aryl, durch Cl, $C_1$-$C_4$-Alkyl oder $C_1$-$C_4$-Alkoxy substituiertes Phenyl, $C_1$-$C_4$-Halogenalkyl oder $C_2$-$C_8$-Alkoxyalkyl bedeutet, $R^6$ Wasserstoff ist oder eine der für $R^5$ gegebenen Bedeutungen hat oder $R^5$ und $R^6$ zusammen $C_4$-$C_5$-Alkylen oder 3-Oxapentamethylen bedeuten.

**8.** Titanocene gemäss Anspruch 1, dadurch gekennzeichnet, dass $R^1$ Cyclopentadienyl$^{\ominus}$ oder Methylcyclopentadienyl$^{\ominus}$, insbesondere Cyclopentadienyl$^{\ominus}$, ist, $R^2$ und $R^3$ eine Gruppe der Formel III oder IV bedeuten, worin entweder
a) Y -CO- oder -$SO_2$- ist und $R^5$ $C_1$-$C_{20}$-Alkyl, $C_2$-$C_8$-Alkenyl, $C_5$-$C_6$-Cycloalkyl, $C_6$-$C_{14}$-Alkylcycloalkyl, $C_6$-$C_{10}$-Aryl, $C_7$-$C_{18}$-Alkaryl oder Chlorphenyl bedeutet, oder
b) Y -CO-O- ist und $R^5$ $C_1$-$C_8$-Alkyl oder Phenyl bedeutet, oder
c) Y -CO-$NR^6$- ist und $R^5$ $C_1$-$C_{12}$-Alkyl, Cyclohexyl oder Phenyl bedeutet und $R^6$ Wasserstoff oder $C_1$-$C_4$-Alkyl bedeutet oder $R^5$ und $R^6$ zusammen Pentamethylen oder 3-Oxapentamethylen bedeuten, oder
d) Y -$Si(R^4)_2$- ist und $R^4$ $C_1$-$C_4$-Alkyl ist und $R^5$ $C_1$-$C_8$-Alkyl oder Phenyl bedeutet.

**9.** Titanocene gemäss Anspruch 1, dadurch gekennzeichnet, dass $R^1$ Cyclopentadienyl$^{\ominus}$ ist und $R^2$ und $R^3$ eine Gruppe der Formel III oder IV bedeuten, worin entweder
a) Y -CO- ist und $R^5$ $C_1$-$C_{20}$-Alkyl oder $C_2$-$C_4$-Alkenyl bedeutet, oder
b) Y -CO-$NR^6$- ist und $R^5$ $C_1$-$C_6$-Alkyl und $R^6$ Wasserstoff oder $C_1$-$C_4$-Alkyl bedeuten, oder
c) Y -$SO_2$- ist und $R^5$ Phenyl oder p-Tolyl bedeutet, oder
d) Y -CO-O ist und $R^5$ $C_1$-$C_8$-Alkyl bedeutet, oder
e) Y -$Si(R^4)_2$ ist und $R^4$ $C_1$-$C_4$-Alkyl ist und $R^5$ $C_1$-$C_8$-Alkyl bedeutet.

**10.** Verfahren zur Herstellung von Titanocenen der Formel I gemäss Anspruch 1, worin $R^2$ und $R^3$ durch einen Rest der Formel -O-Y-$R^5$ substituiert sind, dadurch gekennzeichnet, dass man eine Verbindung der Formel I, worin $R^2$ und $R^3$ durch eine Gruppe - OH substituiert sind,
a) entweder mit einer Verbindung $R^5$-Y-X, worin X Halogen, vorzugsweise Chlor bedeutet, oder
b) mit einer Verbindung $(R^5CO)_2O$ oder
c) mit einer Verbindung $R^5NCO$ oder $R^5NCS$ umsetzt.

**11.** Verbindungen der Formel I

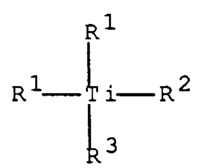 (I),

worin beide $R^1$ unabhängig voneinander gegebenenfalls durch $C_1$-$C_{18}$-Alkyl, $C_1$-$C_{18}$-Alkoxy, $C_2$-$C_{18}$-Alkenyl, $C_5$-$C_8$-Cycloalkyl, $C_6$-$C_{10}$-Aryl, $C_7$-$C_{16}$-Aralkyl, -$Si(R^4)_3$, -$Ge(R^4)_3$, Cyano oder Halogen substituiertes Cyclopentadienyl$^{\ominus}$, Indenyl$^{\ominus}$ oder 4,5,6,7-Tetrahydroindenyl$^{\ominus}$ bedeuten und $R^4$ $C_1$-$C_{12}$-Alkyl, $C_5$-$C_8$-Cycloalkyl, $C_6$-$C_{10}$-Aryl oder $C_7$-$C_{16}$-Aralkyl bedeutet und $R^2$ und $R^3$ eine Gruppe der Formel VI oder VII

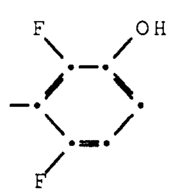 VI 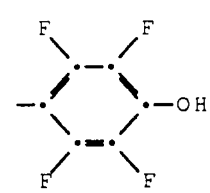 VII .

bedeuten.

**12.** Verbindungen der Formel I gemäss Anspruch 1, worin $R^1$ Cyclopentadienyl$^\ominus$ oder Methylcyclopentadienyl$^\ominus$ ist und $R^2$ und $R^3$ eine Gruppe der Formel VI oder VII bedeuten.

**13.** Durch Strahlung polymerisierbare Zusammensetzung, enthaltend (a) mindestens eine nichtflüchtige, monomere, oligomere oder polymere Verbindung mit mindestens einer polymerisierbaren ethylenisch ungesättigten Doppelbindung und (b) mindestens ein Titanocen der Formel I nach Anspruch 1 als Photoinitiator und (c) gegebenenfalls mindestens einen zusätzlichen von (b) verschiedenen Photoinitiator.

**14.** Zusammensetzung gemäss Anspruch 13, enthaltend als Photoinitiator (c) ein Benzophenon, einen Benzoinalkylether, ein Benzilketal, ein 4-Aroyl-1,3-dioxolan, ein Dialkoxyacetophenon, ein $\alpha$-Hydroxy- oder $\alpha$-Aminoacetophenon oder ein $\alpha$-Hydroxycycloalkylphenylketon oder Mischungen davon als zusätzlichen Photoinitiator.

**15.** Verwendung einer Zusammensetzung gemäss Anspruch 13 zur Herstellung von Lacken, Druckfarben, Druckplatten, Dentalmassen, Resistmaterialien sowie als Bildaufzeichnungsmaterial.

**16.** Beschichtetes Substrat, das auf mindestens einer Oberfläche mit einer Zusammensetzung gemäss Anspruch 13 beschichtet ist.

**17.** Verfahren zur photographischen Herstellung von Reliefabbildungen, dadurch gekennzeichnet, dass man ein beschichtetes Substrat gemäss Anspruch 16 bildmässig belichtet und die unbelichteten Anteile danach mit einem Lösungsmittel entfernt.

**18.** Verwendung von Titanocenen der Formel I gemäss Anspruch 1 alleine oder zusammen mit anderen Initiatoren als Photoinitiatoren für die Photopolymerisation von nichtflüchtigen monomeren, oligomeren oder polymeren Verbindungen mit mindestens einer polymerisierbaren ethylenisch ungesättigten Doppelbindung.

**19.** Photoinitiatorengemisch, enthaltend einen Photoinitiator vom Typ der Benzophenone, Benzoinalkylether, Benzilketale, 4-Aroyl- 1,3-dioxolane, Diaikoxyacetophenone, $\alpha$-Hydroxyacetophenone, $\alpha$-Hydroxycycloalkylphenylketone, $\alpha$-Aminoacetophenone oder Mischungen hiervon und ein Titanocen der Formel I gemäss Anspruch 1.

## Claims

**1.** A titanocene of the formula I

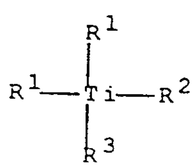

(I),

in which both the $R^1$ radicals, independently of one another, are cyclopentadienyl$^\ominus$, indenyl$^\ominus$ or 4,5,6,7-tetrahydroindenyl$^\ominus$, each of which is unsubstituted, monosubstituted or polysubstituted by $C_1$-$C_{18}$alkyl, $C_1$-$C_{18}$alkoxy, $C_2$-$C_{16}$alkenyl, $C_5$-$C_8$cycloalkyl, $C_6$-$C_{10}$aryl, $C_7$-$C_{16}$aralkyl, -Si($R^4$)$_3$, -Ge($R^4$)$_3$, cyano or halogen, and $R^4$ is $C_1$-$C_{12}$alkyl, $C_5$-$C_8$cycloalkyl, $C_6$-$C_{10}$aryl or $C_7$-$C_{16}$aralkyl, $R^2$ is a 6-membered carbocyclic or 5- or 6-membered heterocyclic aromatic ring which is substituted by fluorine atoms at least in the two ortho-positions to the titanium-carbon bond, and in which the aromatic ring may contain further substituents, and $R^3$, independently, is as defined for $R^2$, $R^2$ and $R^3$ in the titanocenes being substituted by a radical of the formula II

-O-Y-$R^5$ II

in which Y is a -CO-, -CS-, -CO-O-, -$SO_2$-, -Si($R^4$)$_2$-, -CO-N$R^6$-, -CS-N$R^6$-or -$SO_2$-NR6- group, $R^5$ is

linear or branched $C_1$-$C_{20}$alkyl, $C_2$-$C_{20}$alkenyl,$C_3$-$C_8$cycloalkyl, $C_4$-$C_{20}$cycloalkylalkyl, $C_4$-$C_{20}$alkylcycloalkyl, $C_5$-$C_{20}$alkylcycloalkylalkyl, $C_6$-$C_{20}$cycloalkenylalkyl, $C_7$-$C_{20}$bicycloalkyl, $C_6$-$C_{14}$aryl, $C_7$-$C_{12}$aralkyl, $C_7$-$C_{20}$alkylaryl or $C_8$-$C_{20}$alkylaralkyl, these radicals being unsubstituted or substituted by $C_1$-$C_{16}$alkoxy, $C_1$-$C_{12}$alkylthio, $C_1$-$C_{18}$alkylsulfonyl, $C_6$-$C_{10}$arylsulfonyl, $C_7$-$C_{20}$alkylarylsulfonyl, - COOH, -CN, -COOR$^4$, -CO-($C_1$-$C_{20}$alkyl) or halogen, $R^6$ is hydrogen or has one of the meanings mentioned for $R^5$, or $R^5$ and $R^6$ together are $C_3$-$C_7$alkylene, which may be interrupted by -O-, -S- or -N($R^7$)-, in which $R^7$ is hydrogen, $C_1$-$C_{12}$alkyl, $C_3$-$C_{12}$alkenyl, $C_7$-$C_{12}$aralkyl or $C_2$-$C_{20}$alkanoyl.

**2.** A titanocene according to claim 1, wherein $R^1$ is cyclopentadienyl$^\ominus$ or methylcyclopentadienyl$^\ominus$, especially cyclopentadienyl$^\ominus$.

**3.** A titanocene according to claim 1, wherein $R^2$ and $R^3$ are identical.

**4.** A titanocene according to claim 1, wherein $R^2$ and $R^3$ are 2,6-difluorophen-1-yl to which a radical of the formula II is bonded, and which may contain a further 1 or 2 identical or different substituents.

**5.** A titanocene according to claim 1, wherein $R^2$ and $R^3$ are a group of the formula III

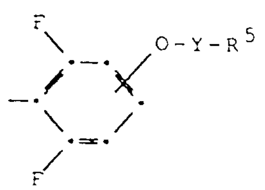

III

in which Y and $R^5$ are as defined in claim 1.

**6.** A titanocene according to claim 1, wherein $R^2$ and $R^3$ are radicals of the formula IV

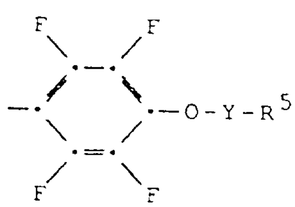

IV

in which Y and $R^5$ are as defined in claim 1.

**7.** A titanocene according to claim 1, wherein $R^2$ and $R^3$ are a group of the formula III or IV in which Y is -CO-, -CO-O-, -$SO_2$-, -CO-NR$^6$-, -CS-NH- or -$SO_2$NR$^6$-, $R^5$ is $C_1$-$C_{12}$alkyl, cyclohexyl, $C_2$-$C_5$alkenyl, cyclohexylmethyl, $C_7$-$C_{12}$aralkyl, $C_6$-$C_{10}$aryl, phenyl which is substituted by Cl, $C_1$-$C_4$alkyl or $C_1$-$C_4$alkoxy or is $C_1$-$C_4$haloalkyl or $C_2$-$C_8$alkoxyalkyl, $R^6$ is hydrogen or has one of the meanings given for $R^5$, or $R^5$ and $R^6$ together are $C_4$-$C_5$alkylene or 3-oxapentamethylene.

**8.** A titanocene according to claim 1, wherein $R^1$ is cyclopentadienyl$^\ominus$ or methylcyclopentadienyl$^\ominus$, especially cyclopentadienyl$^\ominus$, and $R^2$ and $R^3$ are a group of the formula III or IV in which either

a) Y is -CO- or -$SO_2$- and $R^5$ is $C_1$-$C_{20}$alkyl, $C_2$-$C_8$alkenyl, $C_5$-$C_6$cycloalkyl, $C_6$-$C_{14}$alkylcycloalkyl, $C_6$-$c_{10}$aryl, $C_7$-$C_{18}$alkaryl or chlorophenyl, or

b) Y is -CO-O- and $R^5$ is $C_1$-$C_8$alkyl or phenyl, or

c) Y is -CO-NR$^6$- and $R^5$ is $C_1$-$C_{12}$alkyl, cyclohexyl or phenyl and $R^6$ is hydrogen or $C_1$-$C_4$alkyl, or $R^5$ and $R^6$ together are pentamethylene or 3-oxapentamethylene, or

d) Y is -Si($R^4$)$_2$- and $R^4$ is $C_1$-$C_4$alkyl and $R^5$ is $C_1$-$C_8$alkyl or phenyl.

**9.** A titanocene according to claim 1, wherein $R^1$ is cyclopentadienyl$^\ominus$ and $R^2$ and $R^3$ are a group of the formula III or IV in which either

a) Y is -CO- and $R^5$ is $C_1$-$C_{20}$alkyl or $C_2$-$C_4$alkenyl, or
b) Y is -CO-$NR^6$- and $R^5$ is $C_1$-$C_6$alkyl and $R^6$ is hydrogen or $C_1$-$C_4$alkyl, or
c) Y is -$SO_2$- and $R^5$ is phenyl or p-tolyl, or
d) Y is -CO-O and $R^5$ is $C_1$-$C_8$alkyl, or
e) Y is -$Si(R^4)_2$ and $R^4$ is $C_1$-$C_4$alkyl and $R^5$ is $C_1$-$C_8$alkyl.

**10.** A process for the preparation of a titanocene of the formula I according to claim 1, in which $R^2$ and $R^3$ are substituted by a radical of the formula -O-Y-$R^5$, which comprises reacting a compound of the formula I in which $R^2$ and $R^3$ are substituted by an -OH group
a) either with a compound $R^5$-X-Y, in which X is halogen, preferably chlorine, or
b) with a compound $(R^5CO)_2O$, or
c) with a compound $R^5NCO$ or $R^5NCS$.

**11.** A compound of the formula I

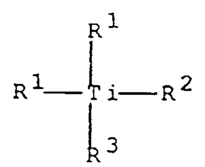

(I),

in which both the $R^1$ radicals, independently of one another, are cyclopentadienyl$^{\ominus}$, indenyl$^{\ominus}$ or 4,5,6,7-tetrahydroindenyl$^{\ominus}$, each of which is unsubstituted or substituted by $C_1$-$C_{18}$alkyl, $C_1$-$C_{18}$alkoxy, $C_2$-$C_{18}$alkenyl, $C_5$-$C_8$cycloalkyl, $C_6$-$C_{10}$aryl, $C_7$-$C_{16}$aralkyl, -$Si(R^4)_3$, -$Ge(R^4)_3$, cyano or halogen, and $R^4$ is $C_1$-$C_{12}$alkyl, $C_5$-$C_8$cycloalkyl, $C_6$-$C_{10}$aryl or $C_7$-$C_{16}$aralkyl, and $R^2$ and $R^3$ are a group of the formula VI or VII

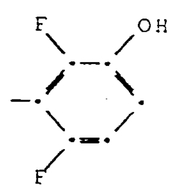

VI

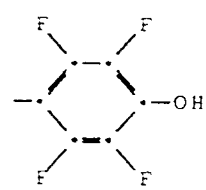

VII .

**12.** A compound of the formula I according to claim 1, in which $R^1$ is cyclopentadienyl$^{\ominus}$ or methylcyclopentadienyl$^{\ominus}$, and $R^2$ and $R^3$ are a group of the formula VI or VII.

**13.** A radiation-polymerizable composition containing (a) at least one non-volatile, monomeric, oligomeric or polymeric compound containing at least one polymerizable ethylenically unsaturated double bond, and (b) at least one titanocene of the formula I according to claim 1 as photoinitiator, and (c) if desired at least one additional photoinitiator which is different from (b).

**14.** A composition according to claim 13, containing, as photoinitiator (c), a benzophenone, a benzoin alkyl ether, a benzil ketal, a 4-aroyl-1,3-dioxolane, a dialkoxyacetophenone, an $\alpha$-hydroxy- or $\alpha$-aminoacetophenone or an $\alpha$-hydroxycycloalkyl phenyl ketone, or mixtures thereof, as additional photoinitiator.

**15.** The use of a composition according to claim 13 for the production of paints, printing inks, printing plates, dental materials, resist materials and as image-recording material.

**16.** A coated substrate which is coated on at least one surface with a composition according to claim 13.

17. A process for the photographic production of relief images, wherein a coated substrate according to claim 16 is exposed imagewise, and the unexposed areas are then removed using a solvent.

18. The use of titanocenes of the formula I according to claim 1 alone or together with other initiators as photoinitiators for the photopolymerization of non-volatile, monomeric, oligomeric or polymeric compounds containing at least one polymerizable ethylenically unsaturated double bond.

19. A photoinitiator mixture containing a photoinitiator of the benzophenone, benzoin alkyl ether, benzil ketal, 4-aroyl-1,3-dioxolane, dialkoxyacetophenone, α-hydroxyacetophenone, α-hydroxycycloalkyl phenyl Ketone, α-aminoacetophenone type, or mixtures thereof, and a titanocene of the formula I according to claim 1.

## Revendications

1. Titanocènes de formule I

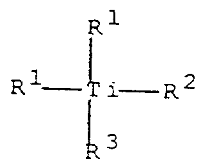

(I),

dans laquelle les deux radicaux $R^1$, indépendamment l'un de l'autre, représentent des radicaux cyclopentadiényle⁻, indényle⁻ ou 4,5,6,7-tétrahydroindényle⁻, éventuellement substitués une ou plusieurs fois par des substituants alkyle ou alcoxy en $C_1$-$C_{18}$, alcényle en $C_2$-$C_{18}$, cycloalkyle en $C_5$-$C_8$, aryle en $C_6$-$C_{10}$, aralkyle en $C_7$-$C_{16}$, $-Si(R^4)_3$, $-Ge(R^4)_3$, cyano ou halogéno, et $R^4$ est un radical alkyle en $C_1$-$C_{12}$, cycloalkyle en $C_5$-$C_8$, aryle en $C_6$-$C_{10}$ ou aralkyle en $C_7$-$C_{16}$, $R^2$ est un noyau aromatique carbocyclique à 6 chaînons ou hétérocyclique à 5 ou 6 chaînons, lequel noyau est substitué par des atomes de fluor au moins dans les deux positions ortho par rapport à la liaison titane-carbone, le noyau aromatique pouvant contenir des substituants supplémentaires, $R^3$ à titre indépendant, a les mêmes significations que $R^2$, les titanocènes étant caractérisés en ce que $R^2$ et $R^3$ sont substitués par un radical de formule II

$-O-Y-R^5$ (II)

dans laquelle Y est un groupe -CO-, -CS-, -CO-O-, $-SO_2-$, $-Si(R^4)_2-$, $-CO-NR^6-$, $-CS-NR^6-$ ou $-SO_2-NR^6-$, $R^5$ est un radical linéaire ou ramifié alkyle en $C_1$-$C_{20}$, alcényle en $C_2$-$C_{20}$, cycloalkyle en $C_3$-$C_8$, cycloalkylalkyle en $C_4$-$C_{20}$, alkylcycloalkyle en $C_4$-$C_{20}$, alkylcycloalkylalkyle en $C_5$-$C_{20}$, cycloalcénylalkyle en $C_6$-$C_{20}$, bicycloalkyle en $C_7$-$C_{20}$, aryle en $C_6$-$C_{14}$, aralkyle en $C_7$-$C_{12}$, alkylaryle en $C_7$-$C_{20}$ ou alkylaralkyle en $C_8$-$C_{20}$, ces radicaux étant non substitués, ou substitués par des substituants alcoxy en $C_1$-$C_{18}$, alkylthio en $C_1$-$C_{12}$, alkylsulfonyle en $C_1$-$C_{18}$, arylsulfonyle en $C_6$-$C_{10}$, alkylarylsulfonyle en $C_7$-$C_{20}$, -COOH, -CN, $-COOR^4$, -CO-(alkyle en $C_1$-$C_{20}$) ou halogéno, $R^6$ est un hydrogène ou a l'une des significatione données pour $R^5$, ou encore $R^5$ et $R^6$ forment ensemble un radical alkylène en $C_3$-$C_7$ pouvant être interrompu par -O-, -S- ou $-N(R^7)-$, où $R^7$ est un hydrogène ou un radical alkyle en $C_1$-$C_{12}$, alcényle en $C_3$-$C_{12}$, aralkyle en $C_7$-$C_{12}$ ou alcanoyle en $C_2$-$C_{20}$.

2. Titanocènes selon la revendication 1, caractérisés en ce que $R^1$ est le radical cyclopentadiényle⁻ ou méthylcyclopentadiényle⁻, en particulier cyclopentadiényle⁻.

3. Titanocènes selon la revendication 1, caractérisés en ce que $R^2$ et $R^3$ ont les mêmes significations.

4. Titanocènes selon la revendication 1, caractérisés en ce que $R^2$ et $R^3$ représentent le radical 2,6-difluorophén-1-yle, auquel est lié un radical de formule II, et qui peut contenir encore un ou deux autres substituants, identiques ou différents.

5. Titanocènes selon la revendication 1, caractérisés en ce que $R^2$ et $R^3$ représentent un groupe de formule III

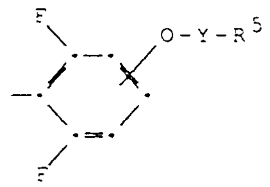

III ,

où Y et $R^5$ ont les significations données dans la revendication 1.

**6.** Titanocènes selon la revendication 1, caractérisée en ce que $R^2$ et $R^3$ sont des radicaux de formule IV

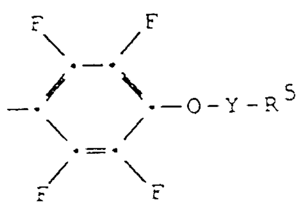

IV

dans laquelle Y et $R^5$ ont les significations données dans la revendication 1.

**7.** Titanocènes selon la revendication 1, caractérisés en ce que $R^2$ et $R^3$ représentent un groupe de formule III ou IV, où Y est -CO-, -CO-O-, $-SO_2-$, $-CO-NR^6-$, -CS-NH- ou $-SO_2NR^6-$, $R^5$ est un radical alkyle en $C_1$-$C_{12}$, cyclohexyle, alcényle en $C_2$-$C_5$, cyclohexylméthyle, aralkyle en $C_7$-$C_{12}$, aryle en $C_6$-$C_{10}$, phényle substitué par des substituants Cl, alkyle en $C_1$-$C_4$ ou alcoxy en $C_1$-$C_4$, halogénoalkyle en $C_1$-$C_4$ ou alcoxyalkyle en $C_2$-$C_8$, $R^8$ est un hydrogène ou a l'une des significations données pour $R^5$, ou encore $R^5$ et $R^6$ forment ensemble un radical alkylène ou 3-oxapentaméthylène.

**8.** Titanocènes selon la revendication 1, caractérisés en ce que $R^1$ est un radical cyclopentadiényle$^-$ ou méthylcyclopentadiényle$^-$, $R^2$ et $R^3$ sont des groupes de formules III ou IV, dans lesquelles :

a) Y est -CO- ou $-SO_2-$, et $R^5$ est un radical alkyle en $C_1$-$C_{20}$, alcényle en $C_2$-$C_8$, cycloalkyle en $C_5$-$C_6$, alkylcycloalkyle en $C_6$-$C_{14}$, aryle en $C_6$-$C_{10}$, alcaryle en $C_7$-$C_{18}$ ou chlorophényle, ou bien

b) Y est -CO-O- et $R^5$ est un radical alkyle en $C_1$-$C_8$ ou phényle, ou bien

c) Y est $-CO-NR^6-$, et $R^5$ est un radical alkyle en $C_1$-$C_{12}$, cyclohexyle ou phényle, et $R^6$ est un hydrogène ou un radical alkyle en $C_1$-$C_4$, ou encore $R^5$ et $R^6$ forment ensemble un radical pentaméthylène ou 3-oxapentaméthylène, ou bien

d) Y est -CO-O-, et $R^5$ est un radical alkyle en $C_1$-$C_8$ou phényle.

**9.** Titanocènes selon la revendication 1, caractérisés en ce que $R^1$ est un radical cyclopentadiényle$^-$, et $R^2$ et $R^3$ sont des groupes de formules III ou IV, dans lesquelles :

a) Y est -CO-, et $R^5$ est un radical alkyle en $C_1$-$C_{20}$ ou alcényle en $C_2$-$C_4$, ou bien

b) Y est $-CO-NR^6-$, et $R^5$ est un radical alkyle en $C_1$-$C_6$, et $R^6$ est un hydrogène ou un radical alkyle en $C_1$-$C_4$, ou bien

c) Y est $-SO_2-$, et $R^5$ est un radical phényle ou paratolyle, ou bien

d) Y est -CO-O et $R^5$ est un radical alkyle en $C_1$-$C_8$, ou bien

e) Y est $-Si(R^4)_2$, et $R^4$ est un radical alkyle en $C_1$-$C_4$, et $R^5$ est un radical alkyle en $C_1$-$C_8$.

**10.** Procédé pour préparer des titanocènes de formule I selon la revendication 1, dans lesquelles $R^2$ et $R^3$ sont substitués par un radical de formule $-O-Y-R^5$, caractérisé en ce qu'on fait réagir un composé de formule I dans laquelle $R^2$ et $R^3$ sont substitués par un groupe -OH

a) avec un composé $R^5$-Y-X où X est un halogène, de préférence le chlore, ou bien

b) avec un composé $(R^5CO)_2O$, ou bien

c) avec un composé $R^5NCO$ ou $R^5NCS$.

**11.** Composés de formule I

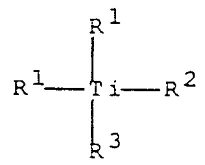

(I),

où les deux radicaux $R^1$, indépendamment l'un de l'autre, sont des radicaux cyclopentadiényle$^-$, indényle$^-$ ou 4,5,6,7-tétrahydroindényle$^-$ éventuellement substitués par des substituants alkyle en $C_1$-$C_{18}$, alcoxy en $C_1$-$C_{18}$, alcényle en $C_2$-$C_{18}$, cycloalkyle en $C_5$-$C_8$, aryle en $C_6$-$C_{10}$, aralkyle en $C_7$-$C_{16}$, -SI$(R^4)_3$, -Ge$(R^4)_3$, cyano ou halogéno, et $R^4$ est un radical alkyle en $C_1$-$C_{12}$, cycloalkyle en $C_5$-$C_8$, aryle en $C_6$-$C_{10}$ ou aralkyle en $C_7$-$C_{16}$, et $R^2$ et $R^3$ représentent un groupe de formule VI ou VII

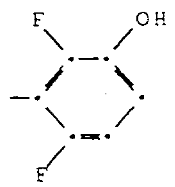

VI

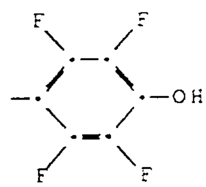

VII

**12.** Composés de formule I selon la revendication 1, dans laquelle $R^1$ est un radical cyclopentadiényle$^-$ ou méthylcyclopentadiényle$^-$, et $R^2$ et $R^3$ sont chacun un groupe de formule VI ou VII.

**13.** Composition polymérisable sous l'effet d'un rayonnement, contenant
a) au moins un composé non volatil, monomère, oligomère ou polymère, comportant au moins une double liaison polymérisable à insaturation éthylénique, et
b) au moins un titanocène de formule I selon la revendication 1, servant de photoamorceur, et
c) éventuellement au moins un photoamorceur supplémentaire différent de b).

**14.** Composition selon la revendication 13, qui contient comme photoamorceurs c) une benzophénone, un éther alkylique de la benzoïne, un benzilecétal, un 4-aroyl-1,3-dioxolanne, une dialcoxyacétophénone, une $\alpha$-hydroxy- ou une $\alpha$-aminoacétophénone, ou encore une $\alpha$-hydroxycycloalkylphénylcétone, ou leurs mélanges, servant de photoamorceurs supplémentaires.

**15.** Utilisation d'une composition selon la revendication 13 pour préparer des vernis, des encres d'imprimerie, des cartes imprimées, des masses dentaires, des matériaux de réserve, ainsi qu'un matériau pour enregistrement d'images.

**16.** Substrat enduit, qui, sur au moins une surface, est enduit d'une composition selon la revendication 13.

**17.** Procédé de fabrication photographique d'images en relief, caractérisé en ce qu'on expose selon l'image un substrat enduit selon la revendication 16, les zones non exposées étant ensuite éliminées à l'aide d'un solvant.

**18.** Utilisation de titanocènes de formule I selon la revendication 1, seuls ou avec d'autres amorceurs, servant de photoamorceurs, pour la photopolymérisation de composés non volatils monomères, oligomères ou polymères, comportant au moins une double liaison polymérisable à insaturation éthylénique.

**19.** Mélange de photoamorceurs contenant un photoamorceur du type des benzophénones, des éthers alkyliques de la benzoïne, des benzilecétals, des 4-aroyl-1,3-dioxolannes, des dialcoxyacétophénones, des $\alpha$-hydroxyacétophénones, des $\alpha$-hydroxycycloalkylphénylcétones, des $\alpha$-aminoacétophénones ou

de leurs mélanges, et un titanocène de formule I selon la revendication 1.